# EUROPEAN PATENT APPLICATION

(11) **EP 4 815 667 A1**
(43) Date of publication of application: **30.09.2026**
(21) Application number: 25217475.0
(22) Date of filing: 20.11.2025
(51) Int. Cl.: H10D 30/47, H10D 62/17, H10D 64/23, H10D 64/20, H10D 62/85

(54) **SEMICONDUCTOR DEVICE**

(30) Priority: 27.03.2025 KR 20250039840
(71) Applicant: Samsung Electronics Co., Ltd., Suwon-si, Gyeonggi-do 16677 (KR)
(72) Inventor: SON, Chaeyeon, Suwon-si (KR); KIM, Jongseob, Suwon-si (KR); PARK, Junhyuk, Suwon-si (KR); KIM, Joonyong, Suwon-si (KR)
(74) Representative: Marks & Clerk LLP

(57) **Abstract**

A semiconductor device includes a channel layer (132); a barrier layer (136) positioned on the channel layer and including a material having a different energy band gap from an energy band gap of the channel layer; a gate electrode (155) positioned on the barrier layer; a gate semiconductor layer (152) positioned between the barrier layer and the gate electrode; a gate spacer (200) including a first gate spacer and a second gate spacer positioned on opposite sides of the gate semiconductor layer and spaced apart from each other; a passivation layer (310) positioned on the barrier layer and covering the gate electrode; and a source electrode (170) and a drain electrode (190) positioned on opposite sides of the gate electrode and connected to the channel layer. The first gate spacer and the second gate spacer cover side surfaces of the gate semiconductor layer and cover at least a portion of side surfaces of the gate electrode.

## Description

### TECHNICAL FIELD

The present disclosure relates to a semiconductor device.

### BACKGROUND

In modern society, semiconductor devices are closely related to our daily lives. In particular, the importance of power semiconductor devices used in various fields such as transportation (e.g., electric vehicles, railways, and electric trams), renewable energy systems (e.g., solar power generation and wind power generation), and mobile devices is gradually increasing. Power semiconductor devices are semiconductor devices used to handle high voltage or high current, and perform functions such as power conversion and control in large power systems or high-power electronic devices. Power semiconductor devices have high durability and the ability to handle high power, allowing them to handle large amounts of current and withstand high voltages. For example, power semiconductor devices may handle voltages from hundreds to thousands of volts and currents from tens to thousands of amperes. Power semiconductor devices may improve the efficiency of electrical energy by minimizing power loss. Additionally, power semiconductor devices may operate stably even in environments such as high temperatures.

These power semiconductor devices may be classified by material; for example, SiC-based and GaN-based power semiconductor devices are available. By manufacturing power semiconductor devices using SiC or GaN instead of existing silicon wafers (Si wafers), the shortcomings of silicon, such as unstable characteristics at high temperatures, may be complemented. SiC power semiconductor devices have high temperature resistance and low power loss, making them suitable for electric vehicles and renewable energy systems. Among them, semiconductor devices with a super junction structure are widely used to improve the trade-off between the forward characteristics and breakdown voltage of power semiconductor devices.

### SUMMARY

The embodiments are intended to provide a semiconductor device whose reliability may be improved.

According to some embodiments, a semiconductor device comprising: a channel layer; a barrier layer positioned on the channel layer and including a material having a different energy band gap from an energy band gap of the channel layer; a gate electrode positioned on the barrier layer; a gate semiconductor layer positioned between the barrier layer and the gate electrode; a gate spacer including a first gate spacer and a second gate spacer positioned on opposite sides of the gate semiconductor layer and spaced apart from each other; a passivation layer positioned on the barrier layer and covering the gate electrode; and a source electrode and a drain electrode positioned on opposite sides of the gate electrode and connected to the channel layer, wherein the first gate spacer and the second gate spacer cover side surfaces of the gate semiconductor layer and cover at least a portion of side surfaces of the gate electrode.

According to some embodiments, a semiconductor device comprising: a channel layer; a barrier layer positioned on the channel layer and including a material having a different energy band gap from an energy band gap of the channel layer; a gate electrode positioned on the barrier layer; a gate semiconductor layer positioned between the barrier layer and the gate electrode; a gate spacer positioned on a side surface of the gate semiconductor layer; a passivation layer including AION, positioned on the barrier layer and the gate electrode; and a source electrode and a drain electrode positioned on opposite sides of the gate electrode and connected to the channel layer, wherein the gate spacer is positioned between the passivation layer and the gate semiconductor layer, and the passivation layer covers at least a portion of a side surface of the gate electrode.

According to some embodiments, a semiconductor device comprising: a channel layer including GaN; a barrier layer including AlGaN, positioned on the channel layer; a gate electrode positioned on the barrier layer; a gate semiconductor layer including GaN doped with p-type impurities, positioned between the barrier layer and the gate electrode; a first gate spacer and a second gate spacer positioned on opposite side surfaces of the gate semiconductor layer and spaced apart from each other; a passivation layer including Al and N, positioned on the barrier layer, the first gate spacer, the second gate spacer, and the gate electrode; a protection layer positioned on the passivation layer; and a source electrode and a drain electrode positioned on opposite sides of the gate electrode and connected to the channel layer, wherein a distance between the upper surface of the first gate spacer and the upper surface of the channel layer is less than or equal to a distance between the upper surface of the gate electrode and the upper surface of the channel layer.

According to some embodiments, a method for manufacturing a semiconductor device includes the steps of forming a barrier layer including a material having a different energy band gap from an energy band gap of the channel layer on a channel layer, forming a gate semiconductor layer and a gate electrode on the barrier layer, forming a gate spacer material layer on an upper surface of the barrier layer, a side surface of the gate semiconductor layer, and an upper surface of the gate electrode, etching the gate spacer material layer to expose the gate electrode and forming a gate spacer including a first gate spacer and a second gate spacer positioned on opposite sides of the gate semiconductor layer and spaced apart from each other, forming a passivation layer on the upper surface of the barrier layer and the upper surface of the gate electrode, and forming a source electrode and a drain electrode penetrating the passivation layer and the barrier layer and connected to the channel layer.

The first gate spacer and the second gate spacer may cover side surfaces of the gate semiconductor layer and may cover at least a portion of side surfaces of the gate electrode.

The passivation layer may cover a portion of the side surface of the gate electrode.

The upper surface of the gate electrode may be in contact with the passivation layer.

The passivation layer may include AION. The gate spacer may include SiO₂.

After the step of forming the passivation layer, the method may further include a step of forming a protection layer on the passivation layer. A thickness of the passivation layer may be smaller than a thickness of the protection layer.

A N content (at%) in the passivation layer portion adjacent to the drain electrode may be greater than a N content (at%) in the passivation layer portion adjacent to the gate semiconductor layer.

A width of the first gate spacer and a width of the second gate spacer may decrease with increasing distance from the upper surface of the channel layer.

According to embodiments, the reliability of semiconductor devices may be improved.

At least some of the above and other features of the invention are set out in the claims.

### BRIEF DESCRIPTION OF THE DRAWINGS

FIGS. 1 and 2 are cross-sectional views showing a semiconductor device according to some embodiments.
FIG. 3 is an enlarged cross-sectional view of area Q1 of FIG. 1.
FIGS. 4 to 11 are plan views corresponding to region Q1 of FIG. 1, illustrating semiconductor devices according to some embodiments.
FIGS. 12 to 19 are intermediate process cross-sectional views showing a method for manufacturing a semiconductor device according to some embodiments.

### DETAILED DESCRIPTION OF THE EMBODIMENTS

Hereinafter, various embodiments will be described in detail with reference to the attached drawings so that a person having ordinary skill in the art to which the present disclosure pertains may easily implement the embodiments. The present disclosure may be embodied in many different forms and is not limited to the embodiments described herein.

In order to clearly explain the present disclosure, parts irrelevant to the description are omitted, and the same reference numerals are used for identical or similar components throughout the specification.

In addition, the size and the thickness of each component shown in the drawing are arbitrarily shown for convenience of explanation, so the present disclosure is not necessarily limited to what is shown. To clearly represent the various layers and areas in the drawing, the thickness is enlarged and shown. And in the drawings, for convenience of explanation, the thickness of some layers and areas is exaggerated.

Also, when it is said that a part, such as a layer, membrane, region, or plate, is "over" or "on" another part, this includes not only cases where it is "directly over" the other part, but also cases where there are other parts in between. Conversely, when we say that a part is "directly above" another part, we mean that there is no other part in between. Also, being "above" or "on" a reference part means being located above or on the reference part, and does not necessarily mean being located "above" or "on" the opposite direction of gravity.

Additionally, throughout the specification, whenever a part is said to "include" a component, this does not mean that it excludes other components, but rather that it may include other components, unless otherwise specifically stated.

Additionally, throughout the specification, when we say "in plan", we mean when the target portion is viewed from above, and when we say "in cross section", we mean when the target portion is viewed from the side in a cross-section cut vertically.

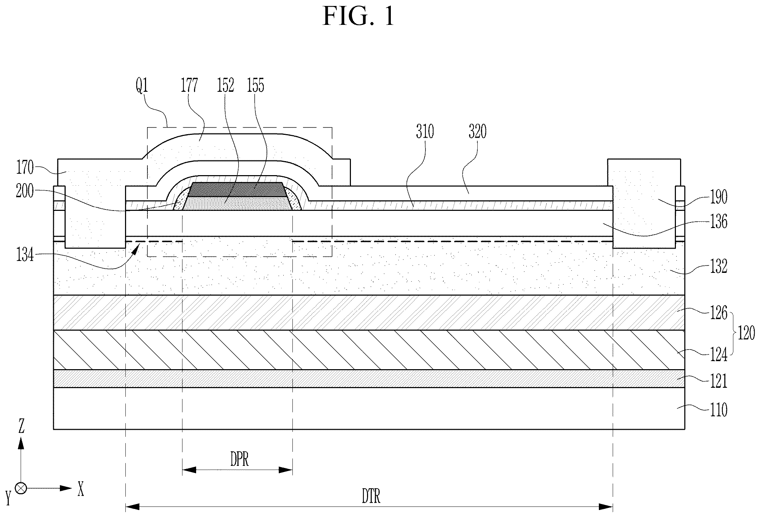

Hereinafter, a semiconductor device according to some embodiments of the present disclosure will be described with referring to FIGS. 1 to 3.

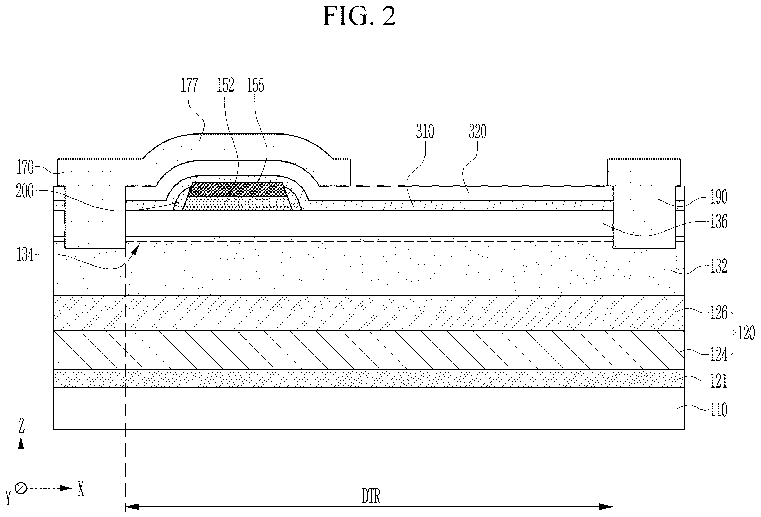

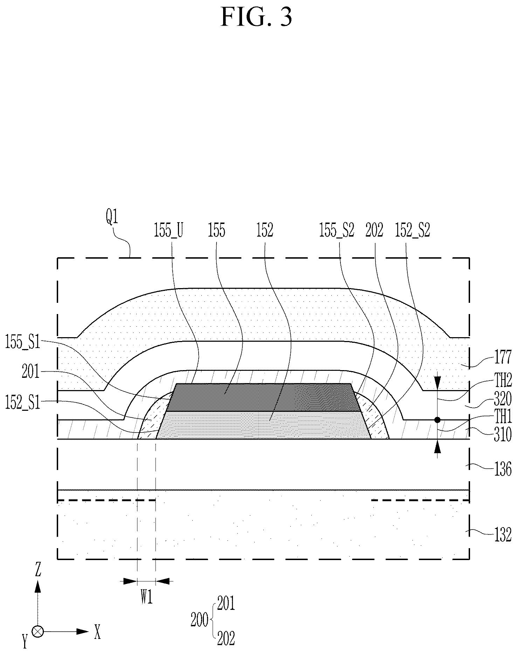

FIGS. 1 and 2 are cross-sectional views showing a semiconductor device according to some embodiments. FIG. 3 is an enlarged cross-sectional view of area Q1 of FIG. 1. FIG. 1 illustrates a case where a semiconductor device according to some embodiments is in an off state. FIG. 2 illustrates a case where a semiconductor device according to some embodiments is in an on state.

Referring to FIGS. 1 and 2, a semiconductor device according to some embodiments includes a channel layer 132, a barrier layer 136 positioned on the channel layer 132, a gate electrode 155 positioned on the barrier layer 136, a gate semiconductor layer 152 positioned between the barrier layer 136 and the gate electrode 155, a gate spacer 200 positioned on opposite sides of the gate semiconductor layer 152, a passivation layer 310 positioned on the barrier layer 136 and covering the gate electrode 155, and a source electrode 170 and a drain electrode 190 positioned on opposite sides of the gate electrode 155 and connected to the channel layer 132.

The channel layer 132 is a layer that forms a channel between the source electrode 170 and the drain electrode 190, and a two-dimensional electron gas (2DEG) 134 may be positioned inside the channel layer 132. The two-dimensional electron gas 134 is a charge transport model used in solid-state physics, which refers to a group of electrons that may move freely in two dimensions (e.g., the x-y plane direction) but cannot move in another dimension (e.g., the z direction) and are tightly bound within the two dimensions. That is, the two-dimensional electron gas 134 may exist in a two-dimensional paper-like form within three-dimensional space. This two-dimensional electron gas 134 mainly appears in semiconductor heterojunction structures, and in a semiconductor device according to some embodiments, it may occur at the interface between the channel layer 132 and the barrier layer 136. For example, the two-dimensional electron gas 134 may be generated in the region adjacent to the barrier layer 136 within the channel layer 132.

The channel layer 132 may include one or more materials selected from group III-V materials, for example, nitrides including Al, Ga, In, B, or combinations thereof. The channel layer 132 may be composed of a single layer or multiple layers. The channel layer 132 may be AlₓIn_{y}Ga_{1-x-y}N (0≤ x ≤ 1, 0≤y≤1, x+y ≤ 1). For example, the channel layer 132 may include Aluminum Nitride (AIN), Gallium Nitride (GaN), Indium Nitride (InN), Indium Gallium Nitride (InGaN), Aluminum Gallium Nitride (AlGaN), Aluminum Indium Nitride (AlInN), Aluminum Indium Gallium Nitride (AlInGaN), or a combination thereof. The channel layer 132 may be a doped layer or an undoped layer. The thickness of the channel layer 132 may be less than about several hundred nm.

The channel layer 132 may be positioned on the substrate 110, and a seed layer 121 and a buffer layer 120 may be positioned between the substrate 110 and the channel layer 132. The substrate 110, the seed layer 121, and the buffer layer 120 are layers used for forming the channel layer 132, and may be omitted in some cases. For example, when the substrate made of GaN is used as the channel layer 132, at least one of the substrate 110, the seed layer 121, and the buffer layer 120 may be omitted. Considering that the substrate made of GaN is relatively expensive, the channel layer 132 including GaN may be grown using a substrate 110 made of Si. In this case, it may not be easy to grow the channel layer 132 directly on the substrate 110 because the lattice structure of Si and the lattice structure of GaN are different. Accordingly, the seed layer 121 and the buffer layer 120 may be grown first on the substrate 110, and then the channel layer 132 may be grown on the buffer layer 120. Additionally, at least one of the substrate 110, the seed layer 121, and the buffer layer 120 may be removed from the final structure of the semiconductor device after being used in the manufacturing process.

The substrate 110 may include a semiconductor material. For example, substrate 110 may include sapphire, Si, SiC, AIN, GaN, or a combination thereof. The substrate 110 may be a Silicon on Insulator (SOI) substrate. However, the material of the substrate 110 is not limited to this, and all commonly used substrates may be applied. In some cases, the substrate 110 may include an insulating material. For example, several layers, including the channel layer 132, may be first formed on a semiconductor substrate, and then the semiconductor substrate may be removed and replaced with an insulating substrate.

The seed layer 121 may be positioned directly on the substrate 110. However, example embodiments are not limited thereto, and other layers may be additionally positioned between the substrate 110 and the seed layer 121. The seed layer 121 is a layer that serves as a seed for growing the buffer layer 120, and may be formed of a crystal lattice structure that serves as the seed of the buffer layer 120. The buffer layer 120 may be positioned directly on the seed layer 121. However, example embodiments are not limited thereto, and other layers may be additionally positioned between the seed layer 121 and the buffer layer 120. The seed layer 121 may include one or more materials selected from group III-V materials, for example, nitrides including Al, Ga, In, B, or combinations thereof. The seed layer 121 may be AlₓIn_{y}Ga_{1-x-y}N (0 ≤ x ≤ 1, 0≤ y≤1, x+y≤1). For example, the seed layer 121 may include AIN, GaN, InN, InGaN, AlGaN, AlInN, AllnGaN, or a combination thereof.

The buffer layer 120 may be positioned on the seed layer 121. The buffer layer 120 may be positioned between the seed layer 121 and the channel layer 132. The buffer layer 120 may be a layer for alleviating the difference in lattice constant and thermal expansion coefficient between the seed layer 121 and the channel layer 132, or for preventing leakage current from flowing through the channel layer 132. The buffer layer 120 may include one or more materials selected from group III-V materials, for example, nitrides including Al, Ga, In, B, or combinations thereof. The buffer layer 120 may be AlₓIn_{y}Ga_{1-x-y}N (0≤x≤1, 0≤y≤1, x+y≤1). For example, the buffer layer 120 may include AIN, GaN, InN, InGaN, AlGaN, AlInN, AlInGaN, or a combination thereof.

The buffer layer 120 of a semiconductor device according to some embodiments may include a superlattice layer 124 positioned on a seed layer 121, and a high-resistivity layer 126 positioned on the superlattice layer 124. The superlattice layer 124 and the high-resistivity layer 126 may be sequentially positioned on the substrate 110.

The superlattice layer 124 may be positioned on the seed layer 121. The superlattice layer 124 may be positioned directly on the seed layer 121. However, example embodiments are not limited thereto, and additional layers may be positioned between the seed layer 121 and the superlattice layer 124. The superlattice layer 124 is a layer for alleviating the difference in lattice constant and coefficient of thermal expansion between the substrate 110 and the channel layer 132, thereby alleviating the tensile stress and compressive stress generated between the substrate 110 and the channel layer 132, and alleviating the stress between all layers formed by growth in the final structure of the semiconductor device according to some embodiments. The superlattice layer 124 may include one or more materials selected from group III-V materials, for example, nitrides including Al, Ga, In, B, or combinations thereof. The superlattice layer 124 may be AlₓIn_{y}Ga_{1-x-y}N (0≤x≤1, 0≤y≤1, x+y≤1). For example, the superlattice layer 124 may include AIN, GaN, InN, InGaN, AlGaN, AlInN, AlInGaN, or a combination thereof.

In some embodiments, the superlattice layer 124 may be formed of multiple layers of alternating layers including different materials. For example, the superlattice layer 124 may have a structure in which layers made of AlGaN and layers made of AIN are repeatedly laminated. AlGaN/AlN/AlGaN/AlN/AlGaN/AlN may be sequentially stacked to form the superlattice layer. The number of AlGaN layers and GaN constituting the superlattice layer 124 may be varied, and the material constituting the superlattice layer 124 may be varied. As another example, the superlattice layer 124 may have a structure in which layers made of AlGaN and layers made of GaN are repeatedly stacked. AlGaN/GaN/AlGaN/GaN/AlGaN/GaN may be sequentially stacked to form a superlattice layer. In some embodiments, when the superlattice layer 124 includes GaN, InN, AlGaN, AlInN, InGaN, AIN, AlInGaN, or a combination thereof, the superlattice layer 124 may have n-type semiconductor properties in which the concentration of electrons is greater than the concentration of holes, but example embodiments are not limited thereto.

The high-resistivity layer 126 may be positioned on the superlattice layer 124. The high-resistivity layer 126 may be positioned directly on the superlattice layer 124. However, example embodiments are not limited thereto, and additional layers may be positioned between the superlattice layer 124 and the high-resistivity layer 126. The high-resistivity layer 126 may be positioned between the superlattice layer 124 and the channel layer 132. The high-resistivity layer 126 is a layer that prevents the semiconductor device according to some embodiments from deteriorating by preventing leakage current from flowing through the channel layer 132. The high-resistivity layer 126 may be formed of a low conductivity material so as to electrically insulate between the substrate 110 and the channel layer 132. The high-resistivity layer may include one or more materials selected from group III-V materials, for example, nitrides including Al, Ga, In, B, or combinations thereof. The high-resistivity layer 126 may be AlₓIn_{y}Ga_{1-x-y}N (0≤x≤1, 0≤y≤1, x+y≤1). For example, the high-resistivity layer 126 may include AIN, GaN, InN, InGaN, AlGaN, AlInN, AlInGaN, or a combination thereof. The high-resistivity layer 126 may be composed of a single layer or multiple layers.

The barrier layer 136 may be positioned on the channel layer 132. The barrier layer 136 may be positioned directly on the channel layer 132. However, example embodiments are not limited thereto, and other layers may be positioned between the channel layer 132 and the barrier layer 136. The region of the channel layer 132 overlapping the barrier layer 136 between the source electrode 170 and the drain electrode 190 may become a drift region DTR. The drift region DTR may be positioned between the source electrode 170 and the drain electrode 190. The drift region DTR may refer to a region where carriers move when a potential difference occurs between the source electrode 170 and the drain electrode 190.

A semiconductor device according to some embodiments may be turned on/off depending on whether voltage is applied to the gate electrode 155 and/or the magnitude of the voltage applied to the gate electrode 155, thereby causing or blocking movement of carriers in the drift region DTR.

The barrier layer 136 may include one or more materials selected from group III-V materials, for example, nitrides including Al, Ga, In, B, or combinations thereof. The barrier layer 136 may be AlₓIn_{y}Ga_{1-x-y}N (0≤x≤1, 0≤y≤1, x+y≤1). The barrier layer 136 may include GaN, InN, AlGaN, AlInN, InGaN, AIN, AlInGaN, or a combination thereof. The energy band gap of the barrier layer 136 may be controlled by the composition ratio of Al and/or In. The barrier layer 136 may be doped with a predetermined impurity. In this case, the impurity doped into the barrier layer 136 may be a p-type dopant capable of providing holes. For example, the impurity doped into the barrier layer 136 may be magnesium (Mg), but example embodiments are not limited thereto. By increasing or decreasing the impurity doping concentration of the barrier layer 136, the threshold voltage, on-resistance, etc. of the semiconductor device according to some embodiments may be controlled.

The barrier layer 136 may include a semiconductor material having different properties than the channel layer 132. The barrier layer 136 may differ from the channel layer 132 in at least one of polarization characteristics, energy band gap, or lattice constant. For example, the barrier layer 136 may include a material having a different energy band gap from an energy band gap of the channel layer 132. In this case, the barrier layer 136 may have a higher energy band gap than an energy band gap of the channel layer 132 and may have a higher electric polarization ratio than the channel layer 132. A two-dimensional electron gas 134 may be induced in the channel layer 132 having a relatively low electrical polarization rate by the barrier layer 136. In this respect, the barrier layer 136 may also be called a channel supply layer or a two-dimensional electron gas supply layer. The two-dimensional electron gas 134 may be formed within a portion of the channel layer 132 positioned below the interface between the channel layer 132 and the barrier layer 136. The two-dimensional electron gas 134 may have very high electron mobilities.

The barrier layer 136 may be composed of a single layer or multiple layers. When the barrier layer 136 is composed of multiple layers, the materials of each layer constituting the multiple layers may have different energy band gaps. In this case, the multiple layers constituting the barrier layer 136 may be arranged so that the energy band gap becomes larger the closer they are to the channel layer 132.

The gate electrode 155 may be positioned on the barrier layer 136. The gate electrode 155 may overlap a portion of the barrier layer 136 in the third direction (Z direction). The gate electrode 155 may overlap a portion of the drift region DTR of the channel layer 132 in the third direction (Z direction). The gate electrode 155 may be positioned between the source electrode 170 and the drain electrode 190. The gate electrode 155 may be spaced apart from the source electrode 170 and the drain electrode 190. For example, the gate electrode 155 may be positioned closer to the source electrode 170 than to the drain electrode 190. That is, the distance between the gate electrode 155 and the source electrode 170 may be smaller than the distance between the gate electrode 155 and the drain electrode 190, but example embodiments are not limited thereto. In some embodiments, the gate electrode 155 may overlap with the field dispersion layer 177, which will be described later, in the third direction (Z direction). Here, the third direction (Z direction) may refer to the thickness direction and/or the vertical direction of the channel layer 132.

Referring further to FIG. 3, the gate electrode 155 may include a first side surface 155_S1 and a second side surface 155_S2 that are opposite to each other. For example, the first side surface 155_S1 of the gate electrode 155 may be a surface facing the source electrode 170, and the second side surface 155_S2 of the gate electrode 155 may be a surface facing the drain electrode 190. The first side surface 155_S1 of the gate electrode 155 may be opposite to the second side surface 155_S2 of the gate electrode 155. The first side surface 155_S1 and the second side surface 155_S2 of the gate electrode 155 may be inclined surfaces inclined at a predetermined angle from the first direction (X direction). Accordingly, in cross-section, the gate electrode 155 may have a tapered shape. That is, a width of the gate electrode 155 in the first direction (X direction) may decrease with increasing distance from the upper surface of the channel layer 132. However, example embodiments are not limited thereto, and the first side surface 155_S1 and the second side surface 155_S2 of the gate electrode 155 may extend in a direction orthogonal to the first direction (X direction). In this case, the width of the gate electrode 155 in the first direction (X direction) may be constant.

A portion of the side surface of the gate electrode 155 may be in contact with the gate spacer 200 to be described later, and the remaining portion may be in contact with the passivation layer 310. For example, A portion of the first side surface 155_S1 of the gate electrode 155 may be in contact with the first gate spacer 201 to be described later, and the remaining portion may be in contact with the passivation layer 310. Additionally, a portion of the second side surface 155_S2 of the gate electrode 155 may be in contact with the second gate spacer 202 to be described later, and the remaining portion may be in contact with the passivation layer 310.

The gate electrode 155 may include a conductive material. For example, the gate electrode 155 may include a metal, a metal alloy, a conductive metal nitride, a metal silicide, a doped semiconductor material, a conductive metal oxide, or a conductive metal nitride. For example, the gate electrode 155 may be formed of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAlN), tungsten nitride (WN), ruthenium (Ru), titanium aluminum (TiAl), titanium aluminum carbide nitride (TiAlC-N), titanium aluminum carbide (TiAlC), titanium carbide (TiC), tantalum carbide nitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or combinations thereof , but example embodiments are not limited thereto. The gate electrode 155 may be formed of a single layer or multiple layers.

In some embodiments, the device may further include a hard mask film positioned on the gate electrode 155. The hard mask film may be a hard mask used when patterning the gate electrode material layer and/or the gate semiconductor layer in the process of forming the gate electrode 155. However, the hard mask film may be removed depending on the etching conditions during etching of the gate electrode material layer and/or the gate semiconductor layer or the cleaning conditions after etching. For example, the hard mask film may include SiO₂, SiN, SiON, or a combination thereof.

The gate semiconductor layer 152 may be positioned between the barrier layer 136 and the gate electrode 155. That is, the gate semiconductor layer 152 may be positioned on the barrier layer 136, and the gate electrode 155 may be positioned on the gate semiconductor layer 152. The gate electrode 155 may be in Schottky contact or ohmic contact with the gate semiconductor layer 152. The gate semiconductor layer 152 may overlap with the gate electrode 155 in the third direction (Z direction). In this case, the gate semiconductor layer 152 may completely overlap the gate electrode 155 in the third direction (Z direction), and the upper surface of the gate semiconductor layer 152 may be entirely covered by the gate electrode 155. That is, the gate semiconductor layer 152 may have substantially the same planar shape as the gate electrode 155. However, example embodiments are not limited thereto, and the gate electrode 155 may be positioned to cover at least a portion of the gate semiconductor layer 152.

Referring further to FIG. 3, the gate semiconductor layer 152 may include a first side surface 152_S1 and a second side surface 152_S2 that face each other. For example, the first side surface 152_S1 of the gate semiconductor layer 152 may be a surface facing the source electrode 170, and the second side surface 152_S2 of the gate semiconductor layer 152 may be a surface facing the drain electrode 190. The first side surface 152_S1 of the gate semiconductor layer 152 may be the opposite surface of the second side surface 152_S2 of the gate semiconductor layer 152. The first side surface 152_S1 and the second side surface 152_S2 of the gate semiconductor layer 152 may be inclined planes inclined at a predetermined angle from the first direction (X direction). Accordingly, in cross-section, the gate semiconductor layer 152 may have a tapered shape. That is, a width of the gate semiconductor layer 152 in the first direction (X direction) may decrease with increasing distance from the upper surface of the channel layer 132. However, example embodiments are not limited thereto, and the first side surface 152_S1 and the second side surface 152_S2 of the gate semiconductor layer 152 may extend in a direction orthogonal to the first direction (X direction).

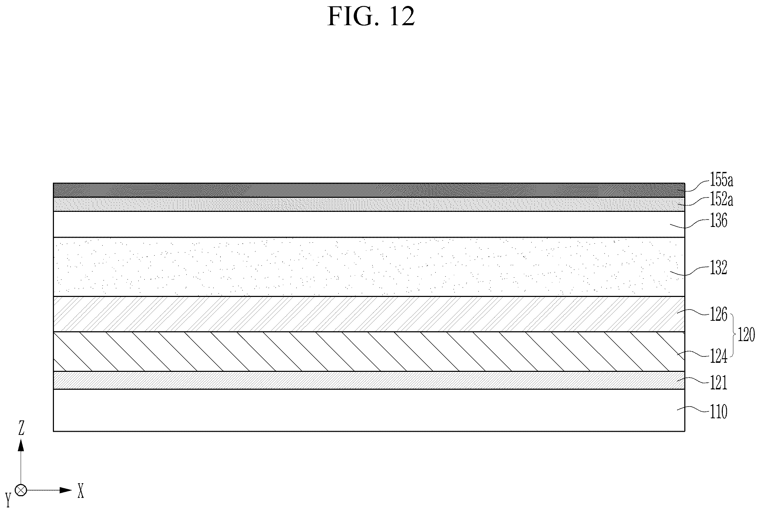

The first side surface 152_S1 of the gate semiconductor layer 152 may extend parallel to the first side surface 155_S1 of the gate electrode 155, and the second side surface 152_S2 of the gate semiconductor layer 152 may extend parallel to the second side surface 155_S2 of the gate electrode 155. This may be due to the process characteristics of forming a gate semiconductor material layer (see 152a of FIG. 12) and a gate electrode material layer (see 155a of FIG. 12), and patterning the gate semiconductor material layer (see 152a of FIG. 12) and the gate electrode material layer (see 155a of FIG. 12) to form the gate semiconductor layer 152 and the gate electrode 155. However, example embodiments are not limited thereto, and the first side surface 152_S1 of the gate semiconductor layer 152 may extend in a different direction from the first side surface 155_S1 of the gate electrode 155, and the second side surface 152_S2 of the gate semiconductor layer 152 may extend in a different direction from the second side surface 155_S2 of the gate electrode 155.

The gate semiconductor layer 152 may be positioned between the source electrode 170 and the drain electrode 190. The gate semiconductor layer 152 may be spaced apart from the source electrode 170 and the drain electrode 190. The gate semiconductor layer 152 may be positioned closer to the source electrode 170 than to the drain electrode 190. That is, the distance between the gate semiconductor layer 152 and the source electrode 170 may be smaller than the distance between the gate semiconductor layer 152 and the drain electrode 190, but example embodiments are not limited thereto.

In some embodiments, the gate semiconductor layer 152 may overlap the gate electrode 155 in the third direction (Z direction). For example, the gate semiconductor layer 152 may completely overlap the gate electrode 155 in the third direction (Z direction). That is, the side surface of the gate semiconductor layer 152 may be aligned with the side surface of the gate electrode 155. However, example embodiments are not limited thereto, and the gate semiconductor layer 152 may partially overlap with the gate electrode 155.

The gate semiconductor layer 152 may include one or more materials selected from group III-V materials, for example, nitrides including Al, Ga, In, B, or combinations thereof. The gate semiconductor layer 152 may be AlₓIn_{y}Ga_{1-x-y}N (0≤x≤1, 0≤y ≤1, x+y≤ 1). For example, the gate semiconductor layer 152 may include AIN, GaN, InN, InGaN, AlGaN, AlInN, AllnGaN, or a combination thereof. The gate semiconductor layer 152 may include a material having a different energy band gap from the barrier layer 136. For example, the gate semiconductor layer 152 may include GaN, and the barrier layer 136 may include AlGaN. The gate semiconductor layer 152 may be doped with a predetermined impurity. In this case, the impurity doped into the gate semiconductor layer 152 may be a p-type dopant capable of providing holes. For example, the gate semiconductor layer 152 may include GaN doped with p-type impurities. That is, the gate semiconductor layer 152 may be formed of a p-GaN layer. However, example embodiments are not limited thereto, and the gate semiconductor layer 152 may be a p-AlGaN layer.

A depletion region DPR may be formed within the channel layer 132 by the gate semiconductor layer 152. The depletion region DPR may be positioned within the drift region DTR and may have a narrower width than the drift region DTR. As the gate semiconductor layer 152 having a different energy band gap from the barrier layer 136 is positioned on the barrier layer 136, the energy band level of the portion of the barrier layer 136 overlapping the gate semiconductor layer 152 may be raised. Accordingly, the depletion region DPR may be formed in the region of the channel layer 132 overlapping the gate semiconductor layer 152. The depletion region DPR may be a region in the channel path of the channel layer 132 where the two-dimensional electron gas 134 is not formed or has a lower electron concentration than the rest of the region. The depletion region DPR may refer to the region where the flow of the two-dimensional electron gas 134 is cut off within the drift region DTR. As the depletion region DPR occurs, no current flows between the source electrode 170 and the drain electrode 190, and the channel path may be blocked. Accordingly, a semiconductor device according to some embodiments may have normally off characteristics.

That is, the semiconductor device according to some embodiments may be a normally-off high electron mobility transistor (HEMT). As shown in FIG. 1, in a normal state where no voltage is applied to the gate electrode 155, the depletion region DPR exists, and the semiconductor device according to some embodiments may be in an off state. As shown in FIG. 2, when a voltage higher than the threshold voltage is applied to the gate electrode 155, the depletion region DPR disappears, and the two-dimensional electron gas 134 may be connected without being disconnected within the drift region DTR. The two-dimensional electron gas 134 may be formed throughout the channel path between the source electrode 170 and the drain electrode 190, and the semiconductor device according to some embodiments may be in an on state. In summary, a semiconductor device according to some embodiments may include semiconductor layers having different electrical polarization characteristics, and a semiconductor layer having a relatively large polarization rate may induce the two-dimensional electron gas 134 in another semiconductor layer heterojunction therewith. This two-dimensional electron gas 134 may be used as a channel between the source electrode 170 and the drain electrode 190, and the flow of this two-dimensional electron gas 134 may be continued or interrupted by controlling the bias voltage applied to the gate electrode 155. In the gate-off state, the flow of the two-dimensional electron gas 134 is blocked, so that no current may flow between the source electrode 170 and the drain electrode 190. As the flow of the two-dimensional electron gas 134 continues in the gate-on state, current may flow between the source electrode 170 and the drain electrode 190.

In the above, the semiconductor device according to some embodiments is described as a normally-off high electron mobility transistor, but example embodiments are not limited thereto. For example, a semiconductor device according to some embodiments may be a normally-on high electron mobility transistor. For a normally-on high electron mobility transistor, the gate semiconductor layer 152 may be omitted, and thus the gate electrode 155 may be positioned directly on the barrier layer 136. That is, the gate electrode 155 may come into contact with the barrier layer 136. In this structure, the two-dimensional electron gas 134 may be used as a channel when no voltage is applied to the gate electrode 155, and current flow may occur between the source electrode 170 and the drain electrode 190. Additionally, when a negative voltage is applied to the gate electrode 155, the depletion region DPR may occur below the gate electrode 155, where the flow of the two-dimensional electron gas 134 is cut off.

The seed layer 121, the superlattice layer 124, the high-resistivity layer 126, the channel layer 132, the barrier layer 136, and the gate semiconductor layer 152 described above may be sequentially stacked on the substrate 110. In a semiconductor device according to some embodiments, at least one of the seed layer 121, the superlattice layer 124, the high-resistivity layer 126, the channel layer 132, the barrier layer 136, and the gate semiconductor layer 152 may be omitted. These layers, including the seed layer 121, the superlattice layer 124, the high-resistivity layer 126, the channel layer 132, the barrier layer 136, and the gate semiconductor layer 152 may be formed of the same base semiconductor material, and the material composition ratio of each layer may be different in consideration of the role of each layer, performance required for the semiconductor device, etc.

The gate spacer 200 may be positioned on the barrier layer 136. The gate spacer 200 may be positioned on side surfaces of the gate semiconductor layer 152. The gate spacer 200 may be positioned on opposite sides of the gate semiconductor layer 152. The gate spacer 200 may be positioned on side surfaces of the gate semiconductor layer 152. The gate spacer 200 may cover side surfaces of the gate semiconductor layer 152. For example, the gate spacer 200 may completely cover side surfaces of the gate semiconductor layer 152. The gate spacer 200 may be positioned on side surfaces of the gate electrode 155. The gate spacer 200 may be positioned on opposite sides of the gate electrode 155. The gate spacer 200 may cover at least a portion of side surfaces of the gate electrode 155.

The gate spacer 200 may be positioned between the passivation layer 310 and the barrier layer 136, which will be described later. The gate spacer 200 may be positioned between the passivation layer 310 and the gate semiconductor layer 152, which will be described later. The gate semiconductor layer 152 and the passivation layer 310 may be separated from each other by the gate spacer 200. The gate spacer 200 may be covered by the passivation layer 310, which will be described later.

Referring further to FIG. 3, the gate spacer 200 of a semiconductor device according to some embodiments may include a first gate spacer 201 positioned on a first side surface 152_S1 of a gate semiconductor layer 152 and a second gate spacer 202 positioned on the second side surface 152_S2 of the gate semiconductor layer 152. The first gate spacer 201 may refer to the gate spacer 200 positioned on the first side surface 152_S1 of the gate semiconductor layer 152, and the second gate spacer 202 may refer to a gate spacer 200 positioned on the second side surface 152_S2 of the gate semiconductor layer 152. That is, the first gate spacer 201 may be positioned on the side surface of the gate semiconductor layer 152 facing the source electrode 170, and the second gate spacer 202 may be positioned on the side surface of the gate semiconductor layer 152 facing the drain electrode 190. The first gate spacer 201 may be in contact with the first side surface 152_S1 of the gate semiconductor layer 152, and the second gate spacer 202 may be in contact with the second side surface 152_S2 of the gate semiconductor layer 152. Additionally, the first gate spacer 201 may be positioned on at least a portion of the first side surface 155_S1 of the gate electrode 155, and the second gate spacer 202 may be positioned on at least a portion of the second side surface 155_S2 of the gate electrode 155.

The first gate spacer 201 and the second gate spacer 202 may be positioned spaced apart from each other. For example, the first gate spacer 201 and the second gate spacer 202 may be spaced apart from each other in the first direction (X direction). The gate semiconductor layer 152 and the gate electrode 155 may be positioned between the first gate spacer 201 and the second gate spacer 202. The first gate spacer 201 and the second gate spacer 202 cover the side surfaces of the gate semiconductor layer 152 and may cover at least a portion of the side surfaces of the gate electrode 155. For example, the first gate spacer 201 may cover the first side surface 152_S1 of the gate semiconductor layer 152 and at least the portion of the first side surface 155_S1 of the gate electrode 155. Additionally, the second gate spacer 202 may cover the second side surface 152_S2 of the gate semiconductor layer 152 and at least a portion of the second side surface 155_S2 of the gate electrode 155. The first gate spacer 201 may completely cover the first side surface 152_S1 of the gate semiconductor layer 152, and the second gate spacer 202 may completely cover the second side surface 152_S2 of the gate semiconductor layer 152, but example embodiments are not limited thereto. The first gate spacer 201 may contact the first side surface 152_S1 of the gate semiconductor layer 152 and the first side surface 155_S1 of the gate electrode 155. The second gate spacer 202 may be in contact with the second side surface 152_S2 of the gate semiconductor layer 152 and the second side surface 155_S2 of the gate electrode 155.

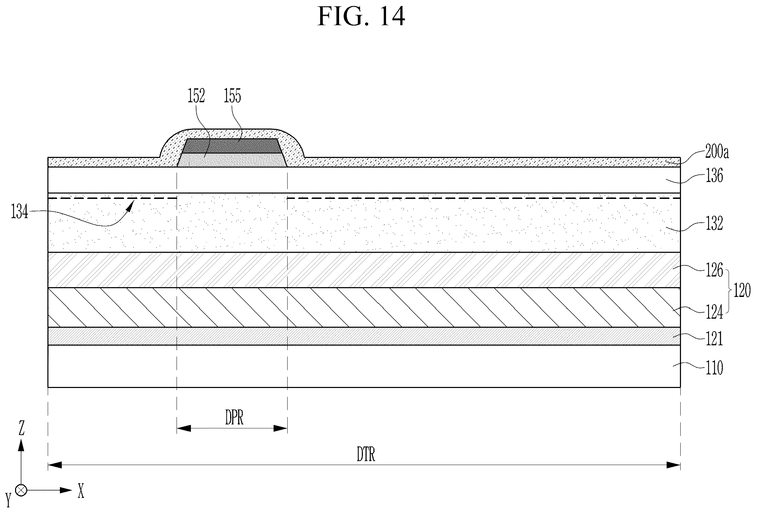

The first gate spacer 201 and the second gate spacer 202 may be symmetric with respect to each other. For example, the first gate spacer 201 and the second gate spacer 202 may be symmetric with respect to the central axis of the gate semiconductor layer 152 in the third direction (Z direction). The first gate spacer 201 and the second gate spacer 202 may be mirror-symmetric with respect to the third direction (Z direction). Here, the third direction (Z direction) may refer to the thickness direction and/or the vertical direction of the channel layer 132. This may be due to the process characteristics of forming a gate spacer material layer (see 200a of FIG. 14) on the upper surface of the barrier layer 136, side surfaces 152_S1, 152_S2 of the gate semiconductor layer 152, side surfaces 155_S1, 155_S2 of the gate electrode 155, and the upper surface 155_U of the gate electrode 155, and simultaneously forming the first gate spacer 201 and the second gate spacer 202 using an etch-back process.

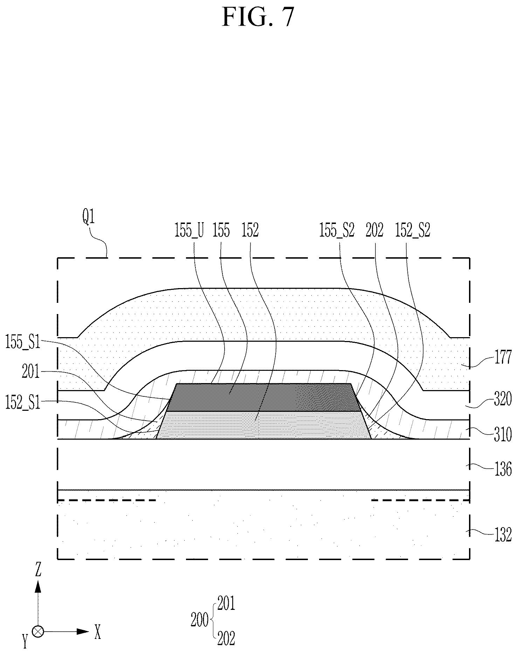

The first gate spacer 201 and the second gate spacer 202 may include convex surfaces. For example, the side surface of the first gate spacer 201 and the side surface of the second gate spacer 202 may have a convex curved shape facing away from the upper surface of the channel layer 132. However, example embodiments are not limited thereto, and the surface of the first gate spacer 201 and the side surface of the second gate spacer 202 may have various shapes. A description of this will be given later, referring to FIG. 7.

A width W1 of the first gate spacer 201 in the first direction (X direction) and the width W1 of the second gate spacer 202 in the first direction (X direction) may include a portion that decreases with increasing distance from the upper surface of the channel layer 132. For example, the width W1 of the first gate spacer 201 in the first direction (X direction) and the width W1 of the second gate spacer 202 in the first direction (X direction) may decrease with increasing distance from the upper surface of the channel layer 132. That is, the width of the first gate spacer 201 portion adjacent to the barrier layer 136 in the first direction (X direction) may be greater than the width of the first gate spacer 201 portion adjacent to the gate electrode 155 in the first direction (X direction). However, example embodiments are not limited thereto, and the first gate spacer 201 and the second gate spacer 202 may further include a portion having a constant width W1 in the first direction (X direction). Alternatively, the first gate spacer 201 and the second gate spacer 202 may further include a portion in which the width W1 in the first direction (X direction) increases with increasing distance from the upper surface of the channel layer 132.

The width W1 of the first gate spacer 201 in the first direction (X direction) and the width W1 of the second gate spacer 202 in the first direction (X direction) may be the same, but example embodiments are not limited thereto. The width W1 of the first gate spacer 201 in the first direction (X direction) and the width W1 of the second gate spacer 202 in the first direction (X direction) may be smaller than the width of the gate semiconductor layer 152 in the first direction (X direction). The width W1 of the first gate spacer 201 in the first direction (X direction) and the width W1 of the second gate spacer 202 in the first direction (X direction) may be smaller than the width of the gate electrode 155 in the first direction (X direction). For example, the width W1 of the first gate spacer 201 in the first direction (X direction) may be about 20 nm to about 100 nm, but example embodiments are not limited thereto.

The length of the first gate spacer 201 in the third direction (Z direction) and the length of the second gate spacer 202 in the third direction (Z direction) may be the same, but example embodiments are not limited thereto. The length of the first gate spacer 201 in the third direction (Z direction) and the length of the second gate spacer 202 in the third direction (Z direction) may be greater than the thickness of the gate semiconductor layer 152 in the third direction (Z direction). The upper surface of the first gate spacer 201 may be positioned at a higher level than the upper surface of the gate semiconductor layer 152. That is, the distance between the upper surface of the first gate spacer 201 and the upper surface of the channel layer 132 may be greater than the distance between the upper surface of the gate semiconductor layer 152 and the upper surface of the channel layer 132. Additionally, the upper surface of the first gate spacer 201 may be positioned at a lower level than the upper surface of the gate electrode 155. That is, the distance between the upper surface of the first gate spacer 201 and the upper surface of the channel layer 132 may be smaller than the distance between the upper surface of the gate electrode 155 and the upper surface of the channel layer 132.

The first gate spacer 201 and the second gate spacer 202 may include an insulating material. The first gate spacer 201 and the second gate spacer 202 may include materials different from the passivation layer 310 described later. For example, the first gate spacer 201 and the second gate spacer 202 may include SiO₂. As another example, the first gate spacer 201 and the second gate spacer 202 may include an oxide such as Al₂O₃ or a carbonate such as SiOC. The first gate spacer 201 and the second gate spacer 202 may not include Nitrogen (N), but example embodiments are not limited thereto. In this case, the leakage current of the semiconductor device may be reduced by effectively preventing carriers from being injected from the passivation layer 310 to the gate semiconductor layer 152.

The passivation layer 310 may be positioned on the barrier layer 136 and the gate electrode 155. The passivation layer 310 may be positioned on the gate spacer 200. The passivation layer 310 may cover the gate electrode 155 and the gate spacer 200. For example, the passivation layer 310 may cover the upper surface of the barrier layer 136, the upper surface 155_U of the gate electrode 155, the side surfaces 155_S1, 155_S2 of the gate electrode 155, and the gate spacer 200. The passivation layer 310 may be conformally positioned on the upper surface of the barrier layer 136, the upper surface 155_U of the gate electrode 155, the side surfaces 155_S1, 155_S2 of the gate electrode 155, and the gate spacer 200. Accordingly, the barrier layer 136 and the gate electrode 155 may be protected by the passivation layer 310. The lower surface of the passivation layer 310 may be in contact with the barrier layer 136, the gate spacer 200, and the gate electrode 155. The passivation layer 310 may be in contact with the upper surface 155_U of the gate electrode 155.

The passivation layer 310 may cover a portion of the side surface of the gate electrode 155. For example, the passivation layer 310 may cover a portion of the first side surface 155_S1 and a portion of the second side surface 155_S2 of the gate electrode 155. The passivation layer 310 may be in contact with a portion of the first side surface 155_S1 and a portion of the second side surface 155_S2 of the gate electrode 155. This may be due to the property of the gate spacer 200 covering at least a portion of the side surfaces of the gate electrode 155.

The passivation layer 310 may be positioned spaced apart from the gate semiconductor layer 152. For example, the passivation layer 310 may be positioned spaced apart from the gate semiconductor layer 152 in the first direction (X direction). The gate spacer 200 may be positioned between the passivation layer 310 and the gate semiconductor layer 152.

The passivation layer 310 may include one or more materials selected from group III-V materials, for example, nitrides including Al, Ga, In, B, or combinations thereof. For example, the passivation layer 310 may include aluminum oxynitride (AION). As another example, the passivation layer 310 may include aluminum nitride (AIN). Accordingly, carriers may be injected from the passivation layer 310 into the channel layer 132, and the two-dimensional electron gas 134 may easily move in the channel layer 132. That is, the on-resistance of semiconductor devices may be improved, and the reliability of semiconductor devices may be enhanced.

Additionally, the permittivity of the passivation layer 310 may be greater than the permittivity of the gate spacer 200. Accordingly, compared to the case where the upper surface 155_U of the gate electrode 155 is covered by the gate spacer 200, the electric field generated by the gate electrode 155 may be effectively dispersed. Additionally, the thermal conductivity of the passivation layer 310 may be greater than the thermal conductivity of the gate spacer 200. Accordingly, compared to the case where the upper surface 155_U of the gate electrode 155 is covered by the gate spacer 200, the reliability of the semiconductor device may be improved by effectively dissipating heat generated in the surroundings.

In some embodiments, the passivation layer 310 may include aluminum (Al) and N. The passivation layer 310 may further include O, but example embodiments are not limited thereto. In this case, a content (an atomic percent: at%) of N in the passivation layer 310 may include a portion that increases with increasing distance from the gate semiconductor layer 152. For example, a N content (at%) in a portion of the passivation layer 310 adjacent to the drain electrode 190 may be greater than a N content (at%) in a portion of the passivation layer 310 adjacent to the gate semiconductor layer 152. For example, the N content (at%) in a portion of the passivation layer 310 adjacent to the drain electrode 190 may be greater than the N content (at%) in a portion of the passivation layer 310 adjacent to the gate spacer 200. Additionally, a N content (at%) in the portion of the passivation layer 310 adjacent to the source electrode 170 may be greater than a N content (at%) in the portion of the passivation layer 310 adjacent to the gate semiconductor layer 152. For example, the N content (at%) in a portion of the passivation layer 310 adjacent to the source electrode 170 may be greater than the N content (at%) in a portion of the passivation layer 310 adjacent to the gate spacer 200. As another example, a N content (at%) in a portion of the passivation layer 310 positioned on the upper surface 155_U of the gate electrode 155 may be less than the N content (at%) in a portion of the passivation layer 310 adjacent to the drain electrode 190. The N content (at%) in the passivation layer 310 portion positioned on the upper surface 155_U of the gate electrode 155 may be lower than the N content (at%) in the passivation layer 310 portion adjacent to the gate spacer 200, but example embodiments are not limited thereto. As another example, the N content (at%) in the passivation layer 310 may have a minimum value in a portion positioned on the upper surface 155_U of the gate electrode 155 and a maximum value in a portion adjacent to the drain electrode 190 and/or the source electrode 170.

In FIGS. 1 to 3, the passivation layer 310 is depicted as being formed of a single layer, but example embodiments are not limited thereto. For example, the passivation layer 310 may be composed of two or more multilayers. In this case, the semiconductor device may include a first passivation layer positioned on the barrier layer 136 and a second passivation layer positioned on the first passivation layer, and the N content (at%) in the first passivation layer may be greater than or equal to the N content (at%) in the second passivation layer, but example embodiments are not limited thereto. As another example, the N content (at%) in the first passivation layer may be less than the N content (at%) in the second passivation layer.

In FIGS. 1 to 3, the passivation layer 310 is depicted as being positioned on the gate electrode 155, but example embodiments are not limited thereto. For example, the gate electrode 155 may penetrate the passivation layer 310 and be connected to the gate semiconductor layer 152, and the passivation layer 310 may not cover the upper surface of the gate electrode 155. The lower surface of the passivation layer 310 may be in contact with the gate semiconductor layer 152.

A semiconductor device according to some embodiments may further include a protection layer 320 positioned on the passivation layer 310.

The protection layer 320 may be positioned on the passivation layer 310. The protection layer 320 may be conformally positioned on the passivation layer 310. The protection layer 320 may have a second thickness TH2 in the third direction (Z direction). The second thickness TH2 of the protection layer 320 in the third direction (Z direction) may be greater than the first thickness TH1 of the passivation layer 310 in the third direction (Z direction). In this case, the occurrence of parasitic capacitance by the passivation layer 310 may be prevented. The protection layer 320 may include various insulating materials. The protection layer 320 may comprise a different material than the passivation layer 310. For example, the protection layer 320 may include an oxide such as SiO₂ or Al₂O₃. As another example, the protection layer 320 may include a nitride such as SiN or an oxynitride such as SiON. In some embodiments, the protection layer 320 and the passivation layer 310 may include Al. In this case, an Al content (at%) in the protection layer 320 may be less than an Al content (at%) in the passivation layer 310.

Additionally, the permittivity of the protection layer 320 may be less than the permittivity of the passivation layer 310. Accordingly, compared to the case where the upper surface 155_U of the gate electrode 155 is covered by the protection layer 320, the electric field generated by the gate electrode 155 may be effectively dispersed. Additionally, the thermal conductivity of the protection layer 320 may be less than the thermal conductivity of the passivation layer 310. Accordingly, compared to the case where the upper surface 155_U of the gate electrode 155 is covered by the protection layer 320, the reliability of the semiconductor device may be improved by effectively dissipating heat generated in the surroundings.

In FIGS. 1 to 3, the protection layer 320 is depicted as being formed of a single layer, but example embodiments are not limited thereto. For example, the protection layer 320 may be composed of two or more multilayers.

The source electrode 170 and the drain electrode 190 may be positioned on the channel layer 132. The source electrode 170 and the drain electrode 190 may be in direct contact with the channel layer 132 and may be electrically connected to the channel layer 132.

The source electrode 170 and the drain electrode 190 may extend in the second direction (Y direction). The source electrode 170 and the drain electrode 190 may be spaced apart from each other, and the gate electrode 155 and the gate semiconductor layer 152 may be positioned between the source electrode 170 and the drain electrode 190. The gate electrode 155 and the gate semiconductor layer 152 may be spaced apart from the source electrode 170 and the drain electrode 190. For example, the source electrode 170 may be electrically connected to the channel layer 132 at one side of the gate electrode 155, and the drain electrode 190 may be electrically connected to the channel layer 132 at the other side of the gate electrode 155. The source electrode 170 and the drain electrode 190 may be positioned outside the drift region DTR of the channel layer 132. The interface between the source electrode 170 and the channel layer 132 may be one edge of the drift region DTR. Similarly, the interface between the drain electrode 190 and the channel layer 132 may be the other edge of the drift region DTR.

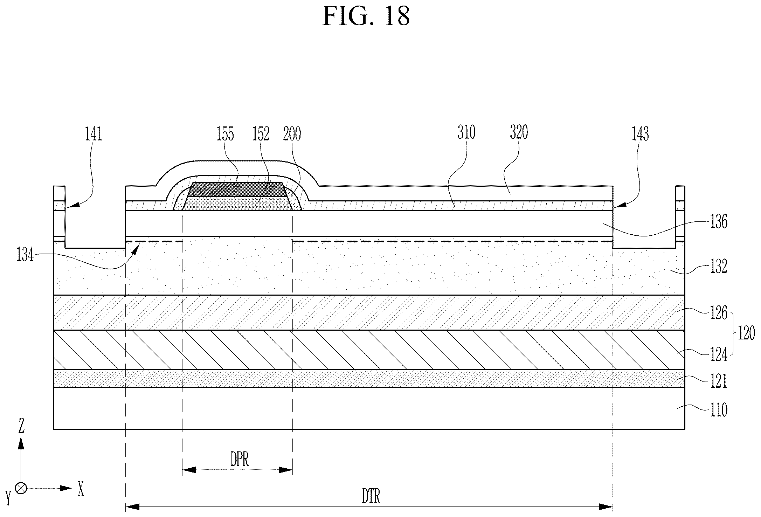

The source electrode 170 and the drain electrode 190 may be positioned within a trench that recesses an upper surface of the channel layer 132. Specifically, trenches (see 141, 143 of FIG. 18) penetrating the protection layer 320, the passivation layer 310, and the barrier layer 136 and recessing the upper surface of the channel layer 132 may be positioned spaced apart from each other on opposite sides of the gate electrode 155. The source electrode 170 and the drain electrode 190 may be positioned in the trenches (see 141, 143 of FIG. 18) positioned on opposite sides of the gate electrode 155, respectively. The source electrode 170 and the drain electrode 190 may be formed to fill the trenches (see 141, 143 of FIG. 18). Within the trenches (see 141, 143 of FIG. 18), the source electrode 170 and the drain electrode 190 may be in contact with the channel layer 132 and the barrier layer 136. The channel layer 132 may form the bottom surface and sidewall of the trenches (see 141, 143 of FIG. 18), and the barrier layer 136 may form the sidewall of the trenches (see 141, 143 of FIG. 18). Accordingly, the source electrode 170 and the drain electrode 190 may be in contact with the upper surface and side surface of the channel layer 132. Additionally, the source electrode 170 and the drain electrode 190 may be in contact with the side surface of the barrier layer 136. That is, the source electrode 170 and the drain electrode 190 may cover the side surfaces of the channel layer 132 and the barrier layer 136. However, example embodiments are not limited thereto, and the channel layer 132 may not be recessed, and the source electrode 170 and the drain electrode 190 may be in contact with the channel layer 132.

In some embodiments, the upper surfaces of the source electrode 170 and the drain electrode 190 may protrude beyond the upper surface of the protection layer 320. The source electrode 170 and the drain electrode 190 may cover at least a portion of a side surface of the protection layer 320. However, example embodiments are not limited thereto, and the source electrode 170 and the drain electrode 190 may cover at least a portion of the side surface of the protection layer 320 and may not cover the remaining portion of the side surface of the protection layer 320. In this case, the remaining portion of the protection layer 320 may be positioned on the upper surfaces of the source electrode 170 and the drain electrode 190.

The source electrode 170 and the drain electrode 190 may include a conductive material. For example, the source electrode 170 and the drain electrode 190 may include a metal, a metal alloy, a conductive metal nitride, a metal silicide, a doped semiconductor material, a conductive metal oxide, or a conductive metal nitride. For example, the source electrode 170 and the drain electrode 190 may be formed of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAlN), tungsten nitride (WN), ruthenium (Ru), titanium aluminum (TiAl), titanium aluminum carbide nitride (TiAlC-N), titanium aluminum carbide (TiAlC), titanium carbide (TiC), tantalum carbide nitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or combinations thereof, but example embodiments are not limited thereto. The source electrode 170 and the drain electrode 190 may be formed of a single layer or multiple layers. The source electrode 170 and the drain electrode 190 may be in ohmic contact with the channel layer 132. The region in contact with the source electrode 170 and the drain electrode 190 within the channel layer 132 may be doped at a relatively high concentration compared to other regions.

FIGS. 1 and 2 illustrate a semiconductor device, according to some embodiments, including a pair of source electrodes 170 and drain electrodes 190, but the number of source electrodes 170 and drain electrodes 190 is not limited thereto. For example, the source electrode 170 may include a plurality of source electrodes sequentially stacked on the channel layer 132 in the third direction (Z direction), and the drain electrode 190 may include a plurality of drain electrodes sequentially stacked on the channel layer 132 in the third direction (Z direction).

A semiconductor device according to some embodiments may further include a field dispersion layer 177 positioned on the protection layer 320.

The field dispersion layer 177 may be positioned between the source electrode 170 and the drain electrode 190. The field dispersion layer 177 may be positioned on the barrier layer 136. The field dispersion layer 177 may be positioned on the protection layer 320, which is positioned on the barrier layer 136. The field dispersion layer 177 may overlap with the channel layer 132 in the third direction (Z direction). In some embodiments, the field dispersion layer 177 may overlap the gate electrode 155 and the gate semiconductor layer 152 in the third direction (Z direction). The field dispersion layer 177 may overlap with the gate spacer 200 in the third direction (Z direction).

The field dispersion layer 177 may be connected to the source electrode 170. The field dispersion layer 177 may extend from one side of the source electrode 170 toward the drain electrode 190. The field dispersion layer 177 may comprise the same material as the source electrode 170. The field dispersion layer 177 may include a conductive material. For example, the field dispersion layer 177 may include a metal, a metal alloy, a conductive metal nitride, a metal silicide, a doped semiconductor material, a conductive metal oxide, or a conductive metal nitride. The field dispersion layer 177 may be formed simultaneously with the source electrode 170 in the same process. The field dispersion layer 177 may be formed integrally with the source electrode 170. However, example embodiments are not limited thereto, and the field dispersion layer 177 may be positioned in a different layer from the source electrode 170 and may be formed in a different process.

The field dispersion layer 177 may serve to disperse the electric field concentrated around the gate electrode 155. Specifically, in the gate-off state, the two-dimensional electron gas 134 may be positioned at a very high concentration in a portion of the channel layer 132 positioned between the gate electrode 155 and the source electrode 170 and in a portion of the channel layer 132 positioned between the gate electrode 155 and the drain electrode 190. In this case, an electric field may be concentrated on the gate electrode 155 or the gate semiconductor layer 152. The gate electrode 155 and the gate semiconductor layer 152 are vulnerable to electric fields, and when the electric field is concentrated, the leakage current may increase and the breakdown voltage of the semiconductor element may decrease. According to some embodiments, the field dispersion layer 177 of the semiconductor device disperses an electric field concentrated around the gate electrode 155 or the gate semiconductor layer 152, thereby reducing leakage current and increasing breakdown voltage.

In embodiments, the number of field dispersion layers 177 may vary. For example, the field dispersion layer 177 may include multiple field dispersion layers positioned on the protection layer 320.

A semiconductor device according to some embodiments may include a passivation layer 310 positioned on the barrier layer 136. The passivation layer 310 may inject carriers into the channel layer 132, and the two-dimensional electron gas 134 may easily move in the channel layer 132. Therefore, the on-resistance of the semiconductor device may be improved, and the reliability of the semiconductor device may be enhanced.

When the passivation layer 310 is positioned adjacent to the gate semiconductor layer 152, leakage current of the semiconductor element may occur. A semiconductor device according to some embodiments may include a first gate spacer 201 and a second gate spacer 202 positioned on opposite sides of the gate semiconductor layer 152 and spaced apart from each other. The first gate spacer 201 and the second gate spacer 202 cover the side surfaces of the gate semiconductor layer 152 and may cover at least a portion of the side surfaces of the gate electrode 155. Accordingly, the passivation layer 310 may be spaced apart from the gate semiconductor layer 152, and carriers may be effectively prevented from being injected from the passivation layer 310 into the gate semiconductor layer 152 by the gate spacer 200, thereby reducing the leakage current of the semiconductor device.

Additionally, the upper surface 155_U of the gate electrode 155 may be in contact with the passivation layer 310. That is, the gate spacer 200 may not be positioned on at least a portion of the gate electrode 155. Accordingly, the passivation layer 310 having a relatively high dielectric constant may be positioned between the field dispersion layer 177 and the gate electrode 155, and an electric field generated by the gate electrode 155 may be effectively dispersed. In addition, since the passivation layer 310 has relatively high thermal conductivity, it may effectively dissipate heat generated in the surroundings, thereby improving the reliability of the semiconductor device.

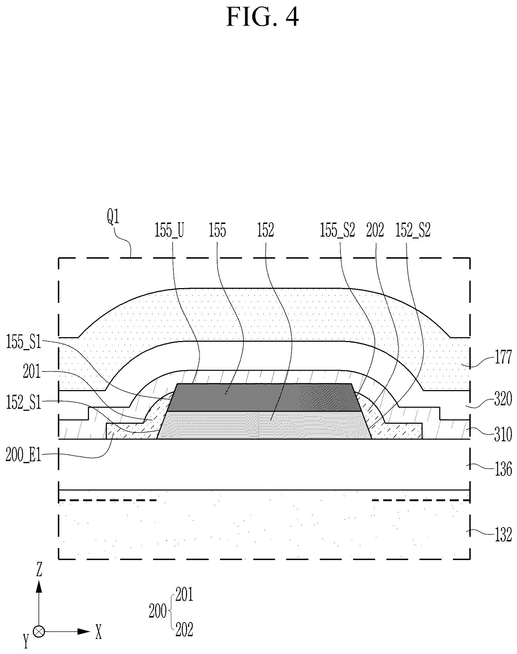

Hereinafter, referring to FIGS. 4 to 11, semiconductor devices according to some embodiments will be described.

FIGS. 4 to 11 are plan views corresponding to region Q1 of FIG. 1, illustrating semiconductor devices according to some embodiments.

FIGS. 4 to 11 illustrate various modifications of a semiconductor device according to some embodiments illustrated in FIGS. 1 to 3. The embodiments illustrated in FIGS. 4 to 11 are substantially the same as the embodiments illustrated in FIGS. 1 to 3, so a description thereof will be omitted and the differences will be mainly explained. Additionally, the same drawing symbols are used for the same components as in the previous embodiment.

Referring to FIG. 4, the gate spacer 200 of the semiconductor device according to some embodiments may further include a first extension 200_E1 positioned on the barrier layer 136.

The first extension 200_E1 may be positioned on the upper surface of the barrier layer 136. The first extension 200_E1 may be positioned directly on the upper surface of the barrier layer 136. The first extension 200_E1 may be positioned between the passivation layer 310 and the barrier layer 136. The first extension 200_E1 may be in contact with the barrier layer 136, but example embodiments are not limited thereto. The first extension 200_E1 may extend from one side of the gate spacer 200 in the first direction (X direction). For example, the first extension 200_E1 may extend from one side of the first gate spacer 201 toward the source electrode 170 in the first direction (X direction). Additionally, the first extension 200_E1 may extend from one side of the second gate spacer 202 toward the drain electrode 190 in the first direction (X direction). The thickness of the first extension 200_E1 in the third direction (Z direction) may be smaller than the width of the first gate spacer 201 in the first direction (X direction). The thickness of the first extension 200_E1 in the third direction (Z direction) may be smaller than the length of the first gate spacer 201 in the third direction (Z direction). The thickness of the first extension 200_E1 in the third direction (Z direction) may be smaller than the thickness of the passivation layer 310 in the third direction (Z direction).

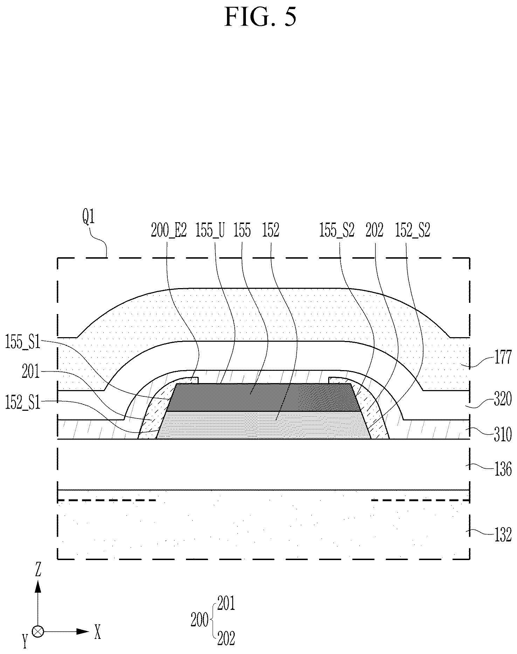

Referring to FIG. 5, the gate spacer 200 of the semiconductor device according to some embodiments may further include a second extension 200_E2 positioned on the gate electrode 155.

The second extension 200_E2 may be positioned on the upper surface 155_U of the gate electrode 155. The second extension 200_E2 may be positioned directly on the upper surface 155_U of the gate electrode 155. The second extension 200_E2 may be positioned between the passivation layer 310 and the gate electrode 155. The second extension 200_E2 may be in contact with the gate electrode 155, but example embodiments are not limited thereto. The second extension 200_E2 may extend from one side of the gate spacer 200 in the first direction (X direction). For example, the second extension 200_E2 may extend from one end of the first gate spacer 201 toward the second gate spacer 202 in the first direction (X direction). Additionally, the second extension 200_E2 may extend from one end of the second gate spacer 202 toward the first gate spacer 201 in the first direction (X direction). The thickness of the second extension 200_E2 in the third direction (Z direction) may be smaller than the width of the first gate spacer 201 in the first direction (X direction). The thickness of the second extension 200_E2 in the third direction (Z direction) may be smaller than the length of the first gate spacer 201 in the third direction (Z direction). The thickness of the second extension 200_E2 in the third direction (Z direction) may be smaller than the thickness of the passivation layer 310 in the third direction (Z direction).

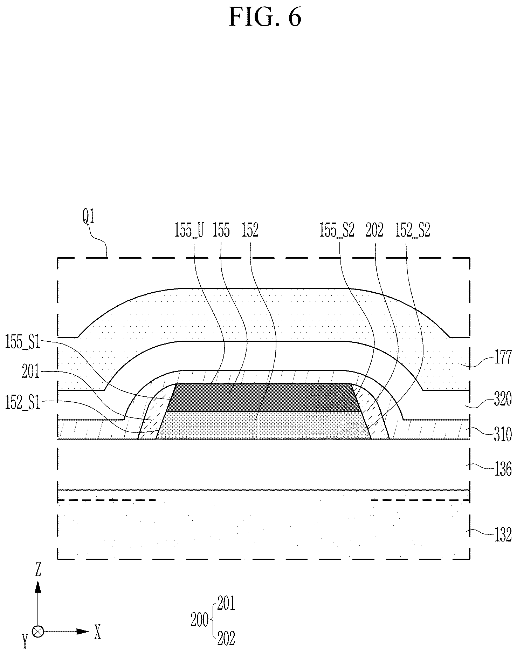

Referring to FIG. 6, the gate spacer 200 may cover the side surfaces of the gate electrode 155. For example, the first gate spacer 201 may completely cover the first side surface 155_S1 of the gate electrode 155, and the second gate spacer 202 may completely cover the second side surface 155_S2 of the gate electrode 155, but example embodiments are not limited thereto. In this case, the upper surface of the gate spacer 200 may be positioned at substantially the same level as the upper surface of the gate electrode 155. The distance between the upper surface of the gate spacer 200 and the upper surface of the channel layer 132 may be substantially equal to the distance between the upper surface 155_U of the gate electrode 155 and the upper surface of the channel layer 132.

Referring to FIG. 7, the gate spacer 200 of the semiconductor device according to some embodiments may have various side surface shapes. For example, one side surface of the gate spacer 200 may have a concave shape facing toward the channel layer 132. Here, one side surface of the gate spacer 200 may refer to the side surface of the gate spacer 200 that is in contact with the passivation layer 310. This may be due to the process characteristics of forming the gate spacer 200 by patterning the gate spacer material layer (see 200a of FIG. 14) using a wet etching method. However, example embodiments are not limited thereto, and one side surface of the gate spacer 200 may be a flat surface inclined at a predetermined angle from the third direction (Z direction).

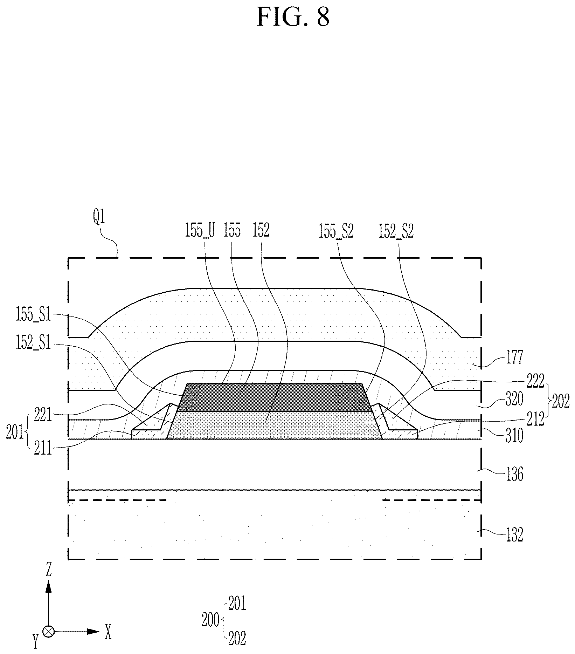

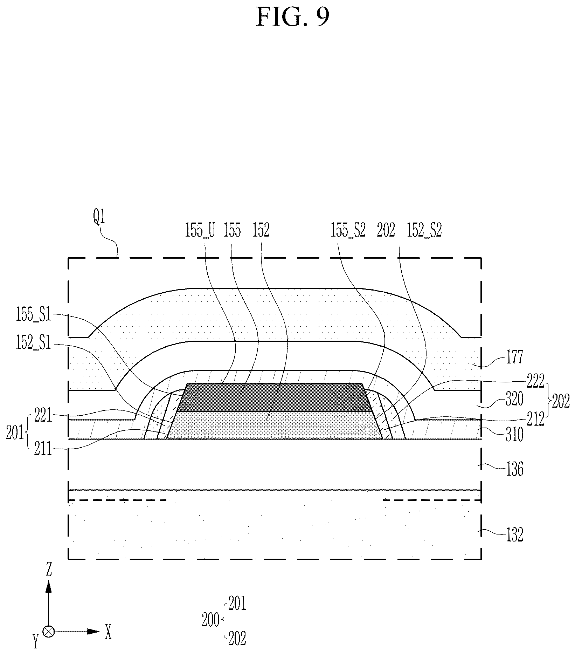

Referring to FIGS. 8 and 9, the gate spacer 200 of a semiconductor device according to some embodiments may include a plurality of spacer patterns 211, 221, 212, 222. For example, the first gate spacer 201 may include a first spacer pattern 211 positioned on the first side surface 152_S1 of the gate semiconductor layer 152 and a second spacer pattern 221 positioned between the first spacer pattern 211 and the passivation layer 310. Additionally, the second gate spacer 202 may include a third spacer pattern 212 positioned on the second side surface 152_S2 of the gate semiconductor layer 152 and a fourth spacer pattern 222 positioned between the third spacer pattern 212 and the passivation layer 310.

The first spacer pattern 211 may be positioned on the upper surface of the barrier layer 136 and the first side surface 152_S1 of the gate semiconductor layer 152. The first spacer pattern 211 may contact the barrier layer 136 and the gate semiconductor layer 152. The first spacer pattern 211 may have various shapes. For example, as illustrated in FIG. 8, the first spacer pattern 211 may be conformally positioned on the upper surface of the barrier layer 136 and the first side surface 152_S1 of the gate semiconductor layer 152. As another example, as illustrated in FIG. 9, the first spacer pattern 211 may be conformally positioned on the first side surface 152_S1 of the gate semiconductor layer 152. As another example, the width of the first spacer pattern 211 in the first direction (X direction) may decrease with increasing distance from the upper surface of the channel layer 132.

The second spacer pattern 221 may be positioned between the first spacer pattern 211 and the passivation layer 310. For example, as illustrated in FIG. 8, the second spacer pattern 221 may be positioned on the first spacer pattern 211. In this case, the second spacer pattern 221 may be positioned spaced apart from the barrier layer 136. The first spacer pattern 211 may be positioned between the second spacer pattern 221 and the barrier layer 136. As another example, as illustrated in FIG. 9, the second spacer pattern 221 may be positioned on the side surface of the first spacer pattern 211. In this case, the second spacer pattern 221 may be positioned on the upper surface of the barrier layer 136. The second spacer pattern 221 may contact the upper surface of the barrier layer 136.

In some embodiments, the first spacer pattern 211 and the second spacer pattern 221 may include different insulating materials. The first spacer pattern 211 may include a different material than the second spacer pattern 221, but example embodiments are not limited thereto. For example, the first spacer pattern 211 may include SiO₂. As another example, the first spacer pattern 211 may include an oxide such as Al₂O₃ or a carbonate such as SiOC. The first spacer pattern 211 may not include N, but example embodiments are not limited thereto. The second spacer pattern 221 may include SiO₂, Al₂O₃, SiOC, or combinations thereof, but example embodiments are not limited thereto.

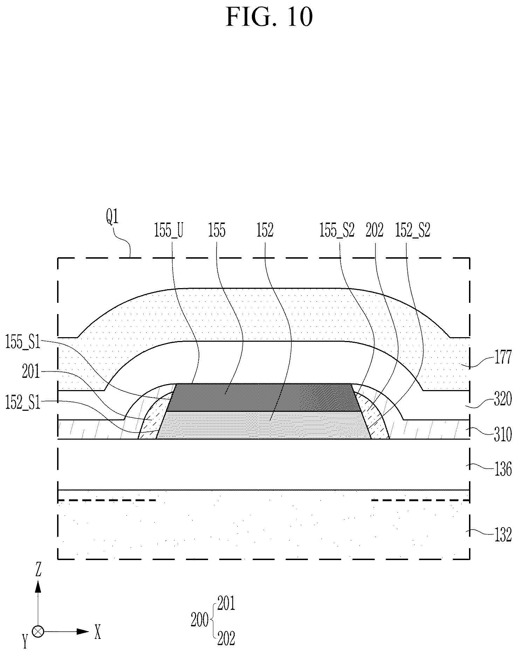

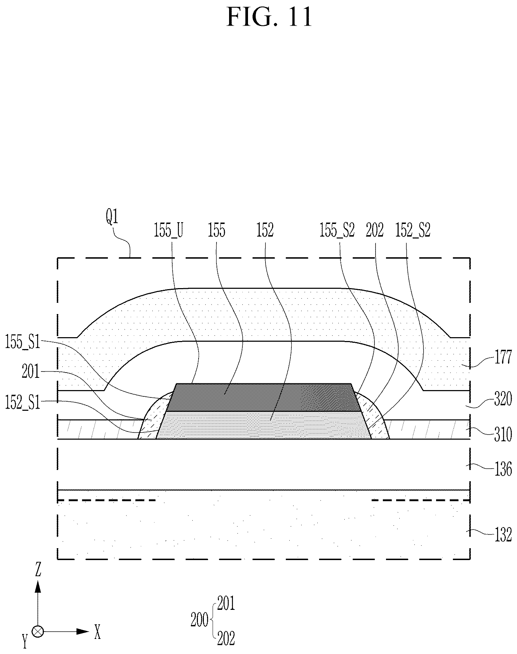

Referring to FIGS. 10 and 11, the passivation layer 310 of the semiconductor device according to some embodiments may have various shapes. For example, as illustrated in FIG. 10, the passivation layer 310 may be positioned on the first side surface 155_S1 and the second side surface 155_S2 of the gate electrode 155, and may not be positioned on the upper surface 155_U of the gate electrode 155. The passivation layer 310 may cover the gate spacer 200. In this case, the protection layer 320 may be positioned on the upper surface 155_U of the gate electrode 155. As another example, as illustrated in FIG. 11, the passivation layer 310 may not be positioned on the first side surface 155_S1 and the second side surface 155_S2 of the gate electrode 155. In this case, the protection layer 320 may be positioned on the first side surface 155_S1 and the second side surface 155_S2 of the gate electrode 155. The protection layer 320 may be in contact with the gate spacer 200, but example embodiments are not limited thereto.

Hereinafter, a method for manufacturing a semiconductor device according to some embodiments of the present disclosure will be described, with referring to FIGS. 12 to 19.

FIGS. 12 to 19 are intermediate process cross-sectional views showing a method for manufacturing a semiconductor device according to some embodiments.

As shown in FIG. 12, a seed layer 121, a buffer layer 120, a channel layer 132, a barrier layer 136, a gate semiconductor material layer 152a, and a gate electrode material layer 155a may be sequentially formed on a substrate 110.

The substrate 110 may include a semiconductor material. For example, the substrate 110 may include sapphire, Si, SiC, AIN, GaN, or a combination thereof. The substrate 110 may be a Silicon on Insulator (SOI) substrate. However, the material of the substrate 110 is not limited to this, and all commonly used substrates may be applied.

The seed layer 121 and the superlattice layer 124 may be formed sequentially using an epitaxial growth method. The seed layer 121 and the superlattice layer 124 may be made of the same base semiconductor material. However, the material composition ratio of each layer may be different depending on the role of each layer and the performance required for the semiconductor device. The seed layer 121 and the superlattice layer 124 may include one or more materials selected from group III-V materials, for example, nitrides including Al, Ga, In, B, or combinations thereof. The seed layer 121 and the superlattice layer 124 may be AlₓIn_{y}Ga_{1-x-y}N (0≤x≤1, 0≤y≤1, x+y≤1). For example, the seed layer 121 and the superlattice layer 124 may include AIN, GaN, InN, InGaN, AlGaN, AlInN, AllnGaN, or a combination thereof.

In some embodiments, the superlattice layer 124 may be formed of multiple layers of alternating layers including different materials. For example, the superlattice layer 124 may have a structure in which layers made of AlGaN and layers made of AIN are repeatedly laminated. That is, AlGaN/AlN/AlGaN/AlN/AlGaN/AlN may be sequentially stacked to form the superlattice layer 124.

The high-resistivity layer 126 may be formed of a low conductivity material so as to electrically insulate between the substrate 110 and the channel layer 132. The high-resistivity layer may include one or more materials selected from group III-V materials, for example, nitrides including Al, Ga, In, B, or combinations thereof. The high-resistivity layer 126 may be AlₓIn_{y}Ga_{1-x-y}N (0≤x≤1, 0≤y≤1, x+y≤1). For example, the high-resistivity layer 126 may include AIN, GaN, InN, InGaN, AlGaN, AlInN, AlInGaN, or a combination thereof. The high-resistivity layer 126 may be composed of a single layer or multiple layers.

In some embodiments, the channel layer 132 and the barrier layer 136 may be formed sequentially using an epitaxial growth method. For example, the channel layer 132 may be formed on the high-resistivity layer 126, and the barrier layer 136 may be formed on the channel layer 132.

The channel layer 132 and the barrier layer 136 may be made of the same base semiconductor material. However, the material composition ratio of each layer may be different depending on the role of each layer and the performance required for the semiconductor device. The channel layer 132 and the barrier layer 136 may include one or more materials selected from group III-V materials, for example, nitrides including Al, Ga, In, B, or combinations thereof. The channel layer 132 and the barrier layer 136 may be AlₓIn_{y}Ga_{1-x-y}N (0 ≤ x ≤1, 0≤y≤1, x+y≤1). For example, the channel layer 132 and the barrier layer 136 may include AIN, GaN, InN, InGaN, AlGaN, AlInN, AllnGaN, or a combination thereof. The barrier layer 136 may include a material having a different energy band gap than the channel layer 132. The barrier layer 136 may have a higher energy band gap than the channel layer 132.

As an example, the substrate 110 may include Si, the seed layer 121 may include AIN, and the superlattice layer 124 may include AlGaN and AIN. The high-resistivity layer 126 may include GaN, the channel layer 132 may include GaN, and the barrier layer 136 may include AlGaN. The channel layer 132 and the barrier layer 136 may be doped with impurities or may be undoped.

The gate electrode material layer 155a may be formed using a deposition process. For example, the gate electrode material layer 155a may be formed using at least one of physical vapor deposition (PVD), thermal chemical vapor deposition (thermal CVD), low pressure chemical vapor deposition (LP-CVD), plasma enhanced chemical vapor deposition (PE-CVD), or atomic layer deposition (ALD) techniques, but example embodiments are not limited thereto.

The gate electrode material layer 155a may include a conductive material. For example, the gate electrode material layer 155a may include a metal, a metal alloy, a conductive metal nitride, a metal silicide, a doped semiconductor material, a conductive metal oxide, or a conductive metal nitride. For example, the gate electrode material layer 155a may be titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAlN), tungsten nitride (WN), ruthenium (Ru), titanium aluminum (TiAl), titanium aluminum carbide nitride (TiAlC-N), titanium aluminum carbide (TiAIC), titanium carbide (TiC), tantalum carbide nitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or combinations thereof, but example embodiments are not limited thereto. The gate electrode material layer 155a may be formed as a single layer or multiple layers.

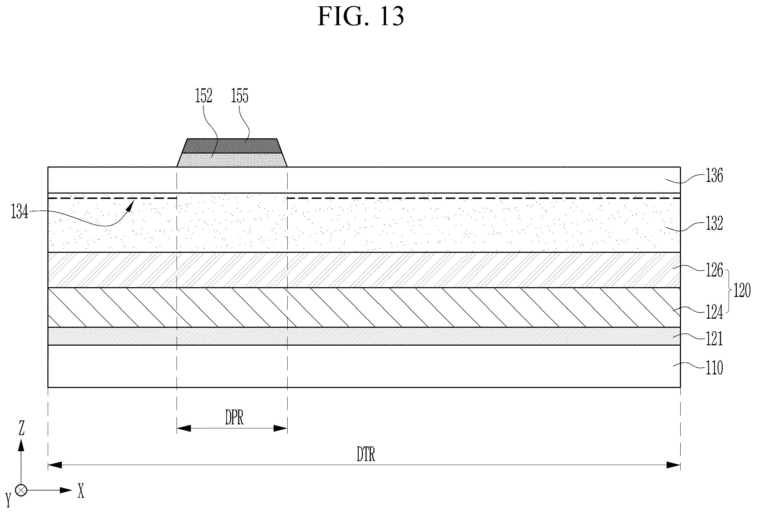

As shown in FIG. 13, the gate electrode 155 and the gate semiconductor layer 152 may be formed by patterning the gate electrode material layer 155a and the gate semiconductor material layer 152a using a photo and etching process.

For example, a hard mask film and a photoresist layer may be sequentially formed on the gate electrode material layer 155a. A photoresist pattern may be formed by patterning a photoresist layer using a photo process. By etching the hard mask film and the gate electrode material layer 155a using the photoresist pattern as a mask, the hard mask pattern and the gate electrode 155 may be formed. Next, by etching the gate semiconductor material layer 152a using the hard mask pattern as a mask, at least a portion of the gate semiconductor material layer 152a may be removed.

Accordingly, the portion of the gate electrode material layer 155a remaining may become the gate electrode 155. Additionally, the remaining portion of the gate semiconductor material layer 152a may become the gate semiconductor layer 152. The gate semiconductor layer 152 is positioned between the barrier layer 136 and the gate electrode 155. The gate electrode 155 may be in Schottky contact or ohmic contact with the gate semiconductor layer 152. In this case, the hard mask film may be removed depending on the etching conditions during the etching of the gate semiconductor material layer or the cleaning conditions after the etching. Alternatively, the hard mask pattern may not be removed and may remain on the gate electrode 155.

By patterning the gate semiconductor material layer 152a and the gate electrode material layer 155a using the same mask, the gate semiconductor layer 152 and the gate electrode 155 may have the same pattern. That is, the gate semiconductor layer 152 and the gate electrode 155 may have the same planar shape. The gate semiconductor layer 152 may completely overlap the gate electrode 155 in the third direction (Z direction), and the upper surface of the gate semiconductor layer 152 may be entirely covered by the gate electrode 155, but example embodiments are not limited thereto. For example, the gate semiconductor layer 152 and the gate electrode 155 may partially overlap in the third direction (Z direction).

As shown in FIG. 14, a gate spacer material layer 200a may be formed on the barrier layer 136 and the gate electrode 155. The gate spacer material layer 200a may be formed using a deposition process. The gate spacer material layer 200a may be conformally positioned on the upper surface of the barrier layer 136, the side surface of the gate semiconductor layer 152, the side surface of the gate electrode 155, and the upper surface of the gate electrode 155. The gate spacer material layer 200a may include SiO₂. As another example, the gate spacer material layer 200a may include an oxide such as Al₂O₃ or a carbonate such as SiOC. The gate spacer material layer 200a may not include N, but example embodiments are not limited thereto.

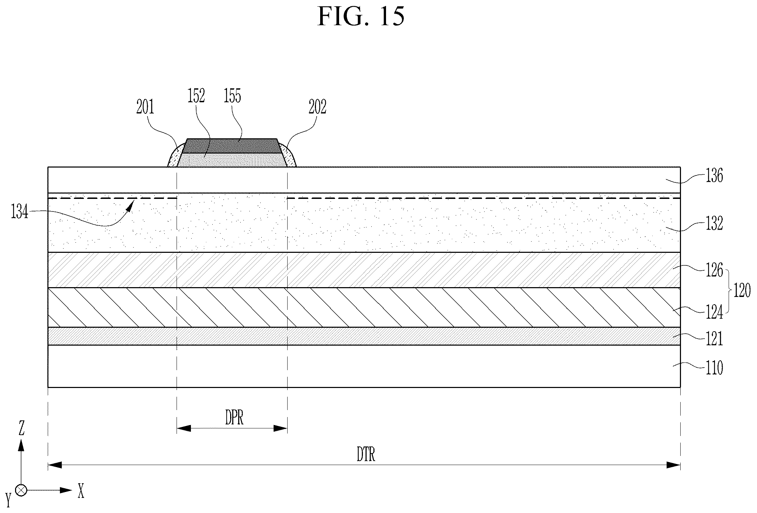

As shown in FIG. 15, the gate spacer material layer 200a is etched to expose the gate electrode 155, and a gate spacer 200 including a first gate spacer 201 and a second gate spacer 202 positioned on opposite sides of the gate semiconductor layer 152 and spaced apart from each other may be formed.

The process of forming the gate spacer 200 by etching the gate spacer material layer 200a may be performed through an etch-back process using a dry etching method. The gate spacer 200 may be positioned on the upper surface of the barrier layer 136 and the side surface of the gate semiconductor layer 152. The gate spacer 200 may cover the side surface of the gate semiconductor layer 152. The gate spacer 200 may be positioned on a side surface of the gate electrode 155. In some embodiments, the gate spacer 200 may completely cover a side surface of the gate semiconductor layer 152 and at least a portion of a side surface of the gate electrode 155.

In some embodiments, the first gate spacer 201 and the second gate spacer 202 may be positioned spaced apart from each other. For example, the first gate spacer 201 and the second gate spacer 202 may be spaced apart from each other in the first direction (X direction). The gate semiconductor layer 152 and the gate electrode 155 may be positioned between the first gate spacer 201 and the second gate spacer 202. The first gate spacer 201 and the second gate spacer 202 may be symmetric with respect to each other. For example, the first gate spacer 201 and the second gate spacer 202 may be symmetric with respect to the central axis of the gate semiconductor layer 152 in the third direction (Z direction). The first gate spacer 201 and the second gate spacer 202 may be mirror-symmetric with respect to the third direction (Z direction). Here, the third direction (Z direction) may refer to the thickness direction and/or the vertical direction of the channel layer 132. This may be due to the process characteristics of simultaneously forming the first gate spacer 201 and the second gate spacer 202 using an etch-back process.

However, example embodiments are not limited thereto, and the gate spacer 200 may be formed using a wet etching method. In this case, as illustrated in the embodiment of FIG. 7, one side surface of the gate spacer 200 may have a concave shape in the direction toward the channel layer 132.

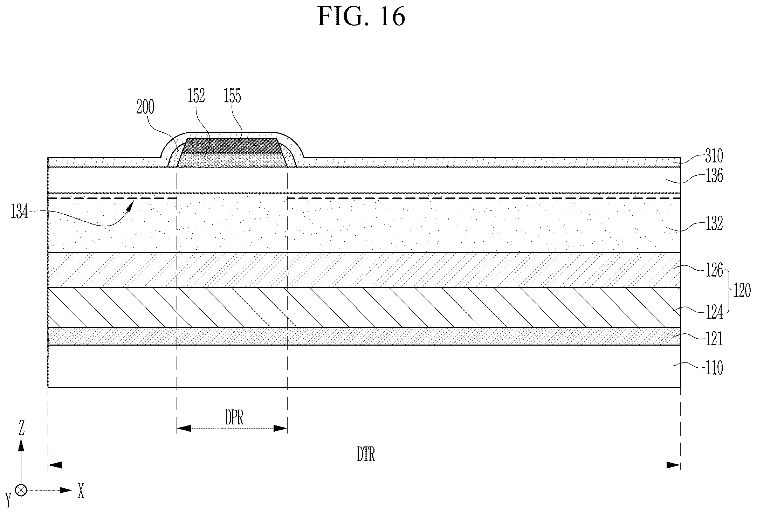

As shown in FIG. 16, a passivation layer 310 may be formed on the upper surface of the barrier layer 136 and the upper surface of the gate electrode 155.

The passivation layer 310 may be formed using a deposition process. For example, the passivation layer 310 may be formed using at least one of, but not limited to, physical vapor deposition (PVD), thermal chemical vapor deposition (thermal CVD), low pressure chemical vapor deposition (LP-CVD), plasma enhanced chemical vapor deposition (PE-CVD), or atomic layer deposition (ALD) techniques.

The passivation layer 310 may be positioned on the barrier layer 136 and the gate electrode 155. The passivation layer 310 may be positioned on the gate spacer 200. The passivation layer 310 may cover the gate electrode 155 and the gate spacer 200. For example, the passivation layer 310 may cover the upper surface of the barrier layer 136, the upper surface 155_U of the gate electrode 155, the side surface of the gate electrode 155, and the gate spacer 200. The passivation layer 310 may be conformally positioned on the upper surface of the barrier layer 136, the upper surface 155_U of the gate electrode 155, the side surface of the gate electrode 155, and the gate spacer 200. Accordingly, the barrier layer 136 and the gate electrode 155 may be protected by the passivation layer 310. The lower surface of the passivation layer 310 may be in contact with the barrier layer 136, the gate spacer 200, and the gate electrode 155. The passivation layer 310 may be in contact with the upper surface 155_U of the gate electrode 155.

The passivation layer 310 may include one or more materials selected from group III-V materials, for example, nitrides including Al, Ga, In, B, or combinations thereof. For example, the passivation layer 310 may include AION. As another example, the passivation layer 310 may include AIN. Accordingly, carriers may be injected from the passivation layer 310 into the channel layer 132, and the two-dimensional electron gas 134 may easily move in the channel layer 132. That is, the on-resistance of semiconductor devices may be improved, and the reliability of semiconductor devices may be enhanced.

Additionally, the permittivity of the passivation layer 310 may be greater than the permittivity of the gate spacer 200. Accordingly, compared to the case where the upper surface 155_U of the gate electrode 155 is covered by the gate spacer 200, the electric field generated by the gate electrode 155 may be effectively dispersed. Additionally, the thermal conductivity of the passivation layer 310 may be greater than the thermal conductivity of the gate spacer 200. Accordingly, compared to the case where the upper surface 155_U of the gate electrode 155 is covered by the gate spacer 200, the reliability of the semiconductor device may be improved by effectively dissipating heat generated in the surroundings.

In some embodiments, the passivation layer 310 may include Al and N. The passivation layer 310 may further include oxygen (O), but example embodiments are not limited thereto. In this case, the content (at%) of N in the passivation layer 310 may include a portion that increases with increasing distance from the gate semiconductor layer 152. For example, the N content (at%) in a portion of the passivation layer 310 adjacent to the drain electrode 190 may be greater than the N content (at%) in a portion of the passivation layer 310 adjacent to the gate semiconductor layer 152.

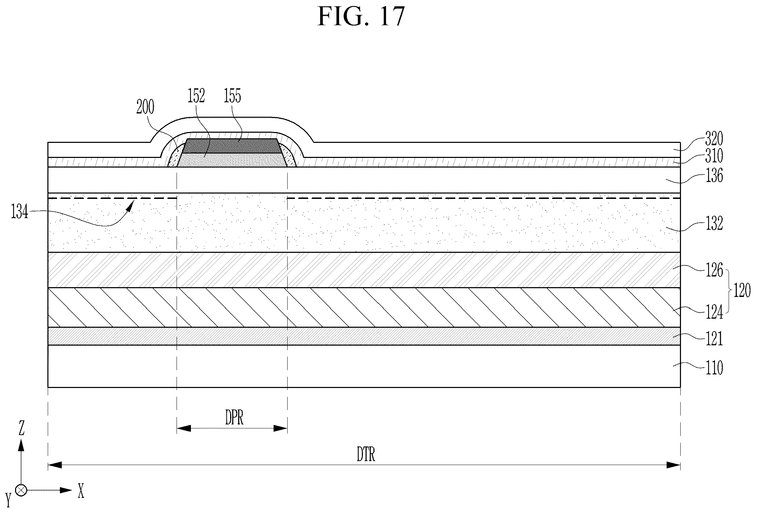

As shown in FIG. 17, a protection layer 320 may be formed on the passivation layer 310. The protection layer 320 may be conformally formed over the passivation layer 310. The thickness of the protection layer 320 in the third direction (Z direction) may be greater than the thickness of the passivation layer 310 in the third direction (Z direction). In this case, the occurrence of parasitic capacitance by the passivation layer 310 may be prevented. The protection layer 320 may include various insulating materials. The protection layer 320 may comprise a different material than the passivation layer 310.

As shown in FIG. 18, the protection layer 320 and the passivation layer 310 may be patterned to form the first trench 141 and the second trench 143.

First, the first trench 141 and the second trench 143 may be formed by patterning the protection layer 320 and the passivation layer 310 using a photo and etching process. In this case, the protection layer 320 and the passivation layer 310 as well as the barrier layer 136 and the channel layer 132 may be patterned together.

For example, a photoresist pattern may be formed on the protection layer 320, and this may be used as a mask to sequentially etch the protection layer 320, the passivation layer 310, the barrier layer 136, and the channel layer 132. In this case, the protection layer 320, the passivation layer 310, and the barrier layer 136 may be penetrated by the first trench 141 and the second trench 143, and the upper surface of the channel layer 132 may be recessed. The channel layer 132 may not be penetrated by first trench 141 or second trench 143. That is, the depth at which the upper surface of the channel layer 132 is recessed may be smaller than the entire thickness of the channel layer 132. In this case, the depth at which the upper surface of the channel layer 132 is recessed may be much smaller than the entire thickness of the channel layer 132. Additionally, the depth at which the upper surface of the channel layer 132 is recessed may be greater than the thickness of the barrier layer 136. However, example embodiments are not limited thereto, and the depth at which the upper surface of the channel layer 132 is recessed may be changed in various ways.

The side surface of the protection layer 320, the side surface of the passivation layer 310, and the side surface of the barrier layer 136 may be exposed to the outside by the first trench 141 and the second trench 143, and the upper surface and the side surface of the channel layer 132 may be exposed. The channel layer 132 may form the bottom surface and sidewall of the first trench 141 and the second trench 143, and the barrier layer 136 may form the sidewall of the first trench 141 and the second trench 143.

The first trench 141 and the second trench 143 may be spaced apart from each other. The first trench 141 and the second trench 143 may be positioned on opposite sides of the gate electrode 155. The first trench 141 may be positioned on one side of the gate electrode 155 and spaced apart from the gate electrode 155. The second trench 143 may be positioned on the other side of the gate electrode 155 and spaced apart from the gate electrode 155. The distance at which the first trench 141 is spaced from the gate electrode 155 may be smaller than the distance at which the second trench 143 is spaced from the gate electrode 155. The width, depth, etc. of the first trench 141 and the second trench 143 are depicted as being similar, but example embodiments are not limited thereto. The shapes of the first trench 141 and the second trench 143 may be varied.

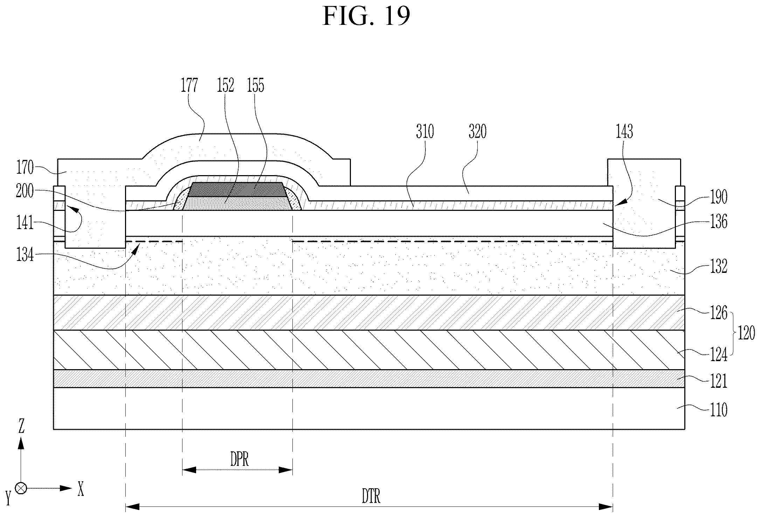

As shown in FIG. 19, a semiconductor device according to some embodiments may be formed by forming the source electrode 170 in a first trench 141 and forming the drain electrode 190 in a second trench 143.

A conductive material may be deposited in the first trench 141 and the second trench 143 and patterned to form the source electrode 170 and the drain electrode 190.

The source electrode 170 and the drain electrode 190 may include a conductive material. For example, the source electrode 170 and the drain electrode 190 may include a metal, a metal alloy, a conductive metal nitride, a metal silicide, a doped semiconductor material, a conductive metal oxide, or a conductive metal nitride. The source electrode 170 and the drain electrode 190 may be formed of a single layer or multiple layers. For example, a plurality of conductive layers including different materials may be laminated and then patterned to form the source electrode 170 and the drain electrode 190.

The source electrode 170 may be formed to fill the interior of the first trench 141. Additionally, the source electrode 170 may be formed to cover at least a portion of an upper surface of the protection layer 320. Accordingly, at least a portion of the source electrode 170 may overlap the channel layer 132 and the barrier layer 136 in the third direction (Z direction). Within the first trench 141, the source electrode 170 may contact the channel layer 132 and the barrier layer 136. The source electrode 170 may be in contact with the side surfaces of the channel layer 132 and the barrier layer 136. The source electrode 170 may cover the side surfaces of the channel layer 132 and the barrier layer 136. The source electrode 170 may be electrically connected to the channel layer 132 through the first trench 141. The upper surface of the source electrode 170 may protrude beyond the upper surface of the protection layer 320.

The drain electrode 190 may be formed to fill the interior of the second trench 143. Additionally, the drain electrode 190 may be formed to cover at least a portion of the upper surface of the protection layer 320. Accordingly, at least a portion of the drain electrode 190 may overlap the channel layer 132 and the barrier layer 136 in the third direction (Z direction). Within the second trench 143, the drain electrode 190 may contact the channel layer 132 and the barrier layer 136. The drain electrode 190 may be in contact with the side surfaces of the channel layer 132 and the barrier layer 136. The drain electrode 190 may cover the side surfaces of the channel layer 132 and the barrier layer 136. The drain electrode 190 may be electrically connected to the channel layer 132 through the second trench 143. The upper surface of the drain electrode 190 may protrude beyond the upper surface of the protection layer 320. The source electrode 170 and the drain electrode 190 may be in ohmic contact with the channel layer 132.

In the step of forming the source electrode 170 and the drain electrode 190, the field dispersion layer 177 may be formed together. The field dispersion layer 177 may be positioned between the source electrode 170 and the drain electrode 190. The field dispersion layer 177 may overlap with the gate electrode 155, but example embodiments are not limited thereto. As another example, the field dispersion layer 177 may be positioned spaced apart from the source electrode 170 in the first direction (X direction). The field dispersion layer 177 may be electrically connected to the source electrode 170. The field dispersion layer 177 may be formed integrally with the source electrode 170. The field dispersion layer 177 may include the same material as the source electrode 170 and may be positioned in the same layer as the source electrode 170.

Although the embodiments of the present disclosure have been described in detail above, the scope of the present disclosure is not limited thereto, and various modifications and improvements made by those skilled in the art using the basic concept of the present disclosure defined in the following claims also fall within the scope of the present disclosure.

While this disclosure contains many specific implementation details, these should not be construed as limitations on the scope of what may be claimed, equivalents thereof, as well as claims to be described later. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

## Claims

1. A semiconductor device comprising:
a channel layer (132);
a barrier layer (136) on the channel layer (132) and including a material having a different energy band gap from an energy band gap of the channel layer (132);
a gate electrode (155) on the barrier layer (136);
a gate semiconductor layer (152) between the barrier layer (136) and the gate electrode (155);
a gate spacer (200) including a first gate spacer (201) and a second gate spacer (202), the first gate spacer (201) and the second gate spacer (202) being on opposite sides of the gate semiconductor layer (152), and spaced apart from each other;
a passivation layer (310) on the barrier layer (136) and in contact with the gate electrode (155); and
a source electrode (170) and a drain electrode (190) on opposite sides of the gate electrode (155) and connected to the channel layer (132),
wherein the first gate spacer (201) and the second gate spacer (202) cover at least a portion of side surfaces (155_S1, 155_S2) of the gate electrode (155).

2. The semiconductor device of claim 1,
wherein the passivation layer (310) is in contact with a remaining portion of the side surfaces (155_S1, 155_S2) of the gate electrode (155).

3. The semiconductor device of claim 1 or claim 2,
wherein the gate spacer (200) is between the passivation layer (310) and the barrier layer (136).

4. The semiconductor device of claim 3,
wherein the gate electrode (155) comprises an upper surface (155_U) that faces away from the barrier layer (136), and wherein the upper surface (155_U) of the gate electrode (155) is in contact with the passivation layer (310).

5. The semiconductor device of claim 3 or claim 4,
wherein the gate spacer (200) is between the passivation layer (310) and the gate semiconductor layer (152).

6. The semiconductor device of any preceding claim,
wherein the first gate spacer (201) and the second gate spacer (202) are symmetric with respect to a central axis of the gate semiconductor layer (152), wherein the central axis extends through the gate semiconductor layer (152) from a first surface facing the barrier layer (136) to a second surface facing away from the barrier layer (136).

7. The semiconductor device of any preceding claim,
wherein the passivation layer (310) includes aluminum oxynitride (AION).

8. The semiconductor device of claim 7,
wherein the gate spacer (200) includes SiO₂.

9. The semiconductor device of claim 7 or claim 8, comprising:
a protection layer (320) on the passivation layer (310),
wherein a thickness (TH2) of the protection layer (320) is greater than a thickness (TH1) of the passivation layer (310).

10. The semiconductor device of claim 9,
wherein the protection layer (320) includes aluminum (Al),
wherein an Al content in the protection layer (320) is smaller than an Al content in the passivation layer (310).

11. The semiconductor device of any of claims 7-10,
wherein the passivation layer (310) includes a portion in which a N content increases with an increasing distance away from the gate semiconductor layer (520).

12. The semiconductor device of any of claims 7-11,
wherein a nitrogen (N) content in a first portion of the passivation layer (310) adjacent to the drain electrode (190) is greater than a N content in a second portion of the passivation layer (310) adjacent to the gate semiconductor layer (520).

13. The semiconductor device of any preceding claim,
wherein a width (W1) of the first gate spacer (201) and a width (W1) of the second gate spacer (202) decrease with an increasing distance away from an upper surface of the channel layer (132), wherein the upper surface of the channel layer (132) faces the barrier layer (136), and wherein the width (W1) of the first gate spacer (201) and the width (W1) of the second gate spacer (202) are defined along a direction parallel to the upper surface of the channel layer (132).

14. The semiconductor device of any preceding claim,
wherein a width (W1) of the first gate spacer (201) is smaller than a width (W1) of the gate semiconductor layer (152), wherein the width (W1) of the first gate spacer (201) and the width (W1) of the gate semiconductor layer (152) are defined along a direction parallel to an upper surface of the channel layer (132), wherein the upper surface of the channel layer (132) faces the barrier layer (136).

15. The semiconductor device of claim 14,
wherein the width (W1) of the first gate spacer (201) is 20 nm to 100 nm.
